# EUROPEAN PATENT APPLICATION

(11) **EP 1 975 717 A2**
(43) Date of publication of application: **01.10.2008**
(21) Application number: 08006330.8
(22) Date of filing: 31.03.2008
(51) Int. Cl.: G03F 7/039

(54) **Positive resist compostion and pattern forming method using the same**

(30) Priority: 30.03.2007 JP 2007094784
(71) Applicant: FUJIFILM Corporation, Minato-ku Tokyo (JP)
(72) Inventor: Mizutani, Kazuyoshi, Yoshida-cho, Haibara-gun, Shizuoka (JP); Hirano, Shuji, Yoshida-cho, Haibara-gun, Shizuoka (JP)
(74) Representative: HOFFMANN EITLE

(57) **Abstract**

A positive resist composition, includes: (A) a resin having a property of becoming soluble in an alkali developer under an action of an acid and having a phenolic hydroxyl group and a weight average molecular weight of 1,500 to 3,500; and (B) a compound capable of generating a sulfonic acid upon irradiation with actinic rays or radiation, wherein a ratio of dissolution rates of an exposed area and an unexposed area in an aqueous 2.38 wt% tetramethylammonium hydroxide at 23°C under atmospheric pressure is in a range from 200 to 5,000 times, and a pattern forming method uses the composition.

## Description

### Background of the Invention

### 1. Field of the Invention

The present invention relates to a positive resist composition suitable for use in the ultramicrolithography process such as production of VLSI or a high-capacity microchip or in other photofabrication processes. More specifically, the present invention relates to a positive resist capable of forming a high-resolution pattern by using KrF excimer laser light, electron beam, EUV light or the like. That is, the present invention relates to a positive resist composition suitably usable for fine processing of a semiconductor device, where KrF excimer laser light, electron beam or EUV light is used, and a pattern forming method using the composition.

### 2. Description of the Related Art

In the process of producing a semiconductor device such as IC and LSI, fine processing by lithography using a photoresist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light. At present, other than the excimer laser light, development of lithography using electron beam, X ray or EUV light is proceeding.

The lithography using electron beam or EUV light is positioned as a next-generation or next-next-generation pattern formation technique, and a positive resist with high sensitivity and high resolution is being demanded. Particularly, in order to shorten the wafer processing time, the elevation of sensitivity is very important, but when high sensitivity of a positive resist to electron beam or EUV is sought for, not only reduction of the resolving power but also worsening of the defocus latitude depended on line pitch are incurred and development of a resist satisfying these properties all at the same time is strongly demanded. The defocus latitude depended on line pitch as used herein means a difference in the pattern dimension between a high density portion and a low density portion of a resist pattern and when this difference is large, the process margin is disadvantageously narrowed at the actual pattern formation. How to reduce this difference is one of important problems to be solved in the development of resist technology. The high sensitivity is in a trade-off relationship with high resolution, good pattern profile and good defocus latitude depended on line pitch and it is very important how to satisfy these properties all at the same time.

Furthermore, also in the lithography using KrF excimer laser light, how to satisfy all of high sensitivity, high resolution, good pattern profile and good defocus latitude depended on line pitch at the same time is an important problem, and this problem needs to be solved.

As regards the resist suitable for such a lithography process using KrF excimer laser light, electron beam or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer insoluble or sparingly soluble in an alkali developer but becoming soluble in an alkali developer under the action of an acid (hereinafter simply referred to as a "phenolic acid-decomposable resin"), is being effectively used.

With respect to such a positive resist, there are known some resist compositions using a phenolic acid-decomposable resin obtained by copolymerizing an acid-decomposable acrylate monomer having an alicyclic group as the acid-decomposable group. Examples thereof include positive resist compositions disclosed in U.S. Patent 5,561,194, JP-A-2001-166474 (the term "JP-A" as used herein means an "unexamined published Japanese patent application"), JP-A-2001-166478, JP-A-2003-107708, JP-A-2001-194792 and JP-A-2005-234434. Also, a case using a compound capable of generating a sulfonic acid upon irradiation with actinic rays or radiation and a compound capable of generating a carboxylic acid is disclosed in JP-A-2003-107707.

In these resist compositions using a low-molecular phenol compound as the main component, high dissolution contrast may be obtained but, on the other hand, there is a problem that the performances in terms of defocus latitude depended on line pitch and exposure margin are insufficient.

### Summary of the Invention

An object of the present invention is to solve the problems in the technology for enhancing the performance at the fine processing of a semiconductor device using actinic rays or radiation, particularly, KrF excimer laser light, electron beam or EUV light, and provide a positive resist composition having high sensitivity as well as good performances in terms of defocus latitude depended on line pitch, pattern profile and dissolution contrast, and a pattern forming method using the composition.

The above-described object can be attained by a positive resist composition having the following constructions and a pattern forming method using the composition.
(1) A positive resist composition, comprising:
   (A) a resin having a property of becoming soluble in an alkali developer under an action of an acid and having a phenolic hydroxyl group and a weight average molecular weight of 1,500 to 3,500; and
   (B) a compound capable of generating a sulfonic acid upon irradiation with actinic rays or radiation,
   wherein a ratio of dissolution rates of an exposed area and an unexposed area in an aqueous 2.38 wt% tetramethylammonium hydroxide at 23°C under atmospheric pressure is in a range from 200 to 5,000 times.
(2) The positive resist composition as described in (1) above,
   wherein the resin (A) contains at least one of a repeating unit represented by formula (1) and a repeating unit represented by formula (2): 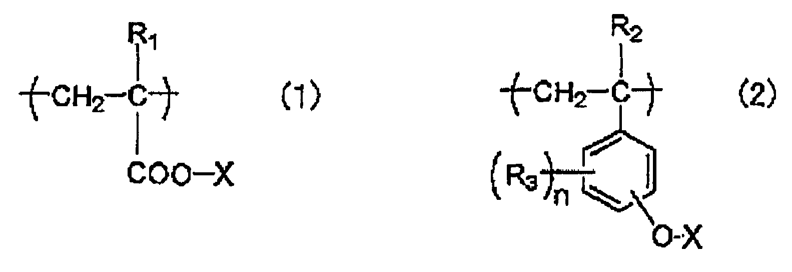 wherein R₁ and R₂ each independently represents a hydrogen atom, a halogen atom, an alkyl group or a cyano group;
   X each independently represents a cyclic hydrocarbon structure-containing group capable of leaving under an action of an acid;
   R₃ represents a monovalent organic group, a nitro group or a halogen atom; and
   n represents an integer of 0 to 4.
(3) The positive resist composition as described in (2) above,
   wherein the cyclic hydrocarbon structure-containing group represented by X in formula (1) is a group represented by any one of formulae (pI) to (pVI): 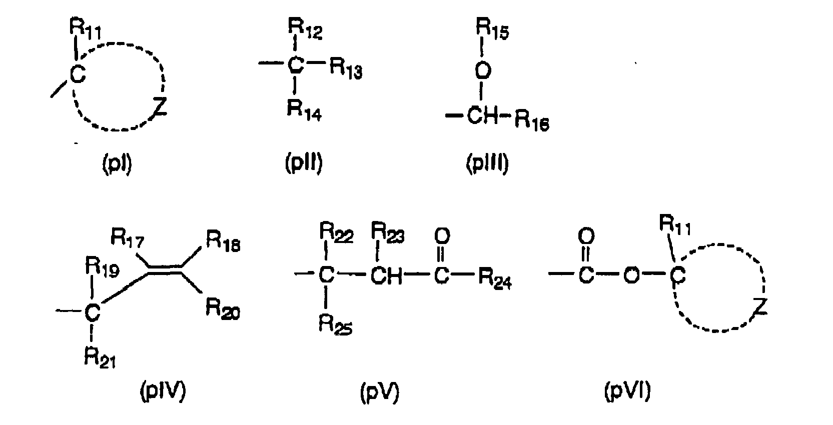 R₁₁ represents a methyl group, an ethyl group, an n-propyl group, an isopropyl group, an n-butyl group, an isobutyl group or a sec-butyl group;
   Z represents an atomic group necessary for forming a cyclic hydrocarbon together with the carbon atom;
   R₁₂ to R₁₆ each independently represents a linear or branched alkyl group having a carbon number of 1 to 4, or a hydrocarbon group, provided that at least one of R₁₂ to R₁₄ or either R₁₅ or R₁₆ represents a cyclic hydrocarbon;
   R₁₇ to R₂₁ each independently represents a hydrogen atom, a linear or branched alkyl group having a carbon number of 1 to 4, or a cyclic hydrocarbon, provided that at least one of R₁₇ to R₂₁ represents a cyclic hydrocarbon, and either R₁₉ or R₂₁ represents a linear or branched alkyl group having a carbon number of 1 to 4, or a cyclic hydrocarbon; and
   R₂₂ to R₂₅ each independently represents a hydrogen atom, a linear or branched hydrocarbon group having a carbon number of 1 to 4, or a cyclic hydrocarbon, provided that at least one of R₂₂ to R₂₅ represents a cyclic hydrocarbon, and R₂₃ and R₂₄ may combine with each other to form a ring.
(4) The positive resist composition as described in (2) or (3) above,
   wherein the cyclic hydrocarbon structure-containing group represented by X in formula (1) is a group represented by formula (3): 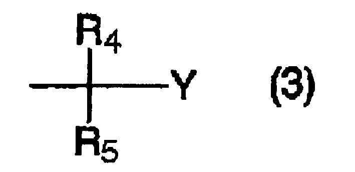 R₄ and R₅ each independently represents an alkyl group; and
   Y represents an alicyclic hydrocarbon group.
(5) The positive resist composition as described in any of (2) to (4) above,
   wherein the resin (A) further contains a cyclic hydrocarbon structure-containing repeating unit which is alkali-insoluble and inert to an acid.
(6) The positive resist composition as described in any of (2) to (5) above,
   wherein the resin (A) further contains a repeating unit represented by formula (A4): 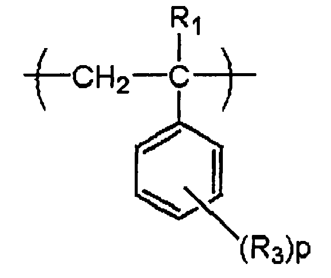 R₁ represents a hydrogen atom, a halogen atom, an alkyl group or a cyano group;
   R₃ represents a monovalent organic group not having a property of decomposing under an action of an acid, or represents a hydrogen atom, a halogen atom or a nitro group; and
   p represents an integer of 0 to 5 and when p is an integer of 2 or more, the plurality of R₃'s may be the same or different.
(7) The positive resist composition as described in any of (1) to (6) above,
   wherein the resin (A) has a weight average molecular weight (Mw) of from 2,000 to 3,000.
(8) The positive resist composition as described in any of (1) to (7) above,
   wherein the resin (A) has a dispersity (Mw/Mn) of 1.5 or less.
(9) The positive resist composition as described in any of (1) to (8) above,
   wherein the resin (A) has a glass transition temperature of from 100 to 150°C.
(10) The positive resist composition as described in (9) above,
   wherein the resin (A) has a glass transition temperature of from 100 to 110°C.
(11) A pattern forming method, comprising:
   forming a resist film from the positive resist composition as described in any of (1) to (10) above; and
   exposing and developing the resist film.

### Detailed Description of the Invention

The compounds for use in the present invention are described in detail below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

### [1] (A) Resin becoming soluble in an alkali developer under the action of an acid

The resin (A) for use in the present invention is a resin having a property of decomposing under the action of an acid to increase the dissolution rate in an alkali developer and having a phenolic hydroxyl group and a weight average molecular weight of 1,500 to 3,500, and this resin is insoluble or sparingly soluble in an alkali developer but becomes soluble in an alkali developer under the action of an acid.

The resin for use in the present invention is a resin capable of decomposing under the action of an acid to increase the dissolution rate and thereby becoming soluble in an alkali developer.

In the positive resist composition of the present invention, the ratio of dissolution rates of the exposed area and the unexposed area in an aqueous 2.38 wt% tetramethylammonium hydroxide at 23°C under atmospheric pressure is in a range from 200 to 5,000 times.

The ratio of the dissolution rate increased corresponds to the difference in the dissolution rate between the exposed area and the unexposed area (dissolution contrast) at the development after pattern exposure.

In the present invention, the difference in the dissolution rate in an aqueous 2.38 wt% tetramethylammonium hydroxide solution, which is a typical alkali developer, at 23°C under atmospheric pressure (1 atm) is used as the indicator.

The ratio of dissolution rates of an exposed area and an unexposed area, as specified in the appended claims, is preferably determined using, for example, a sample that was prepared and irradiated according to the working examples as shown in Table 2 or the working examples as shown in Table 3.

The dissolution rate of the positive resist composition of the present invention increases, under the above-described conditions, in the range of 200 to 5,000 times, preferably from 300 to 2,000 times, more preferably from 500 to 1,000 times.

The positive resist composition having such a dissolution contrast is obtained by controlling the dissolution contrast of the acid-decomposable resin contained, that is, the hydrophilicity/hydrophobicity of the polymer main chain, and appropriately adjusting the molecular weight and molecular weight distribution.

More specifically, in order to reduce the dissolution contrast, for example, methods of 1. increasing the molecular weight of the resin, 2. increasing the molecular weight dispersity, 3. decreasing the size of the group capable of leaving under the action of an acid, 4. decreasing the hydrophobicity of the group capable of leaving under the action of an acid, 5. increasing the pKa of the acidic group generated under the action of an acid, 6. decreasing the hydrophilicity of the resin generated under the action of an acid, and 7. decreasing the glass transition temperature of the resin generated under the action of an acid, are effective. Conversely, in the case of increasing the dissolution contrast, the reverse methods are effective.

In the case of the resin of the present invention having a phenolic hydroxyl group and a weight average molecular weight of 1,500 to 3,500, out of the methods above, more useful are methods of 2. decreasing the molecular weight dispersity, 3. increasing the size of the group capable of leaving under the action of an acid, 4. increasing the hydrophobicity of the group capable of leaving under the action of an acid, and 7. elevating the glass transition temperature of the resin generated under the action of an acid.

Examples of the method of 2. decreasing the molecular weight dispersity include a method of synthesizing a resin by a living polymerization method (for example, a living radical polymerization method described later), and a method where a resin synthesized by a normal polymerization method is fractionated by fractionation chromatography or fractionated with a solvent.

In regard to 3. the size of the group capable of leaving under the action of acid and 4. the hydrophobicity of the group capable of leaving under the action of an acid, as described later, an aromatic-cyclic or alicyclic hydrocarbon structure is preferred.

The method of 7. elevating the glass transition temperature of the resin generated under the action of an acid includes a method of introducing a monomer having a property of restraining the mobility of a polymer, for example, a monomer in which two substituents out of the substituents of a polymerizable C=C group are combined to form a ring (cyclic monomer), a monomer having a hydrogen-bonding linking group (e.g., amide, ureido) in the side chain, or a monomer having a structure of large steric size in the side chain. The monomer having such a property of restraining the mobility of a polymer is preferably contained to account for 5 to 30 mol%, more preferably from 10 to 25 mol%, in the repeating unit of the resin.

In a phenolic hydroxyl group-containing resin such as hydroxystyrene-based resin and novolak resin, reduction of LWR is effective for decreasing the molecular weight, but when the molecular weight is decreased, the dissolution rate in the exposed area becomes excessively high and this causes a problem that round top formation or film loss readily occurs or the defocus latitude depended on line pitch is worsened due to excessive diffusion of the acid generated from the acid generator. In the present invention, this problem is overcome by setting the dissolution contrast to the above-described range.

The resin capable of becoming soluble in an alkali developer under the action of an acid is, for example, a resin containing a monomer which produces an alkali-soluble group under the action of an acid, such as a (meth)acrylic monomer corresponding to the repeating unit represented by formula (1), and this is a resin containing an acid-decomposable group described later. That is, in a (meth)acrylic monomer corresponding to the repeating unit represented by formula (1), X leaves under the action of an acid and a carboxyl group is formed in the monomer.

The resin (A) preferably contains at least either one of a repeating unit represented by formula (1) and a repeating unit represented by formula (2).

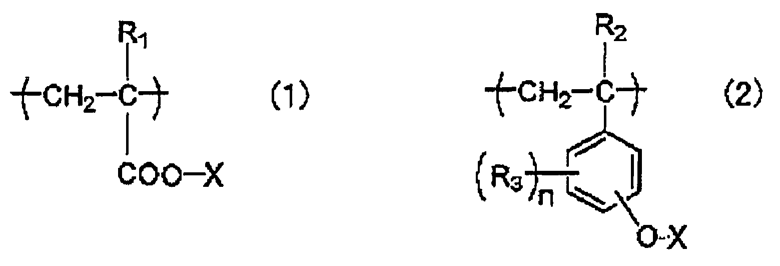

In the formulae, R₁ and R₂ each independently represents a hydrogen atom, a halogen atom, an alkyl group or a cyano group.

X each independently represents a cyclic hydrocarbon structure-containing group capable of leaving under the action of an acid.

R₃ represents a monovalent organic group, a nitro group or a halogen atom.

n represents an integer of 0 to 4.

R₁ and R₂ each is preferably a hydrogen atom, a methyl group or a CₘF₂ₘ₊₁ (m is an arbitrary integer, preferably an integer of 1 to 4, more preferably 1), more preferably a hydrogen atom or a methyl group.

The cyclic hydrocarbon structure-containing group capable of leaving under the action of an acid as X in formula (1) is a group which decomposes under the action of an acid generated upon exposure and generates a carboxylic acid derived from an ester group in the structure of formula (1). The cyclic hydrocarbon structure of X may be an aromatic ring or an alicyclic group and may contain a heteroatom in its structure to form a hetero ring.

The group capable of leaving under the action of an acid as X in formula (1) is more specifically a group represented by any one of the following formulae (pI) to (pVI):

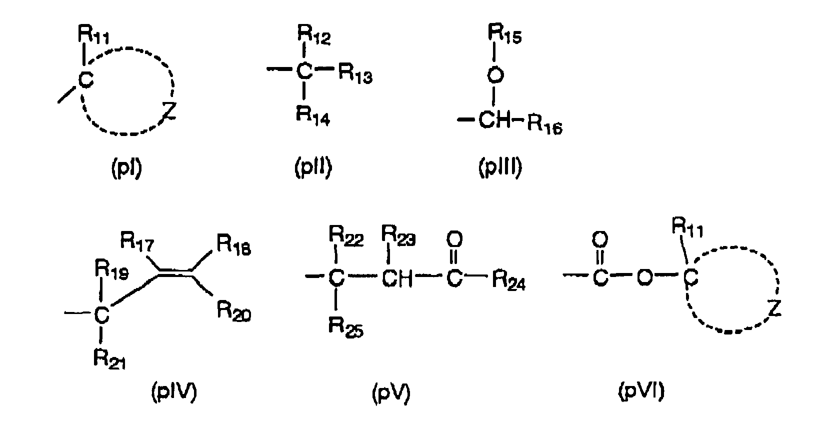

In these formulae, R₁₁ represents a methyl group, an ethyl group, an n-propyl group, an isopropyl group, an n-butyl group, an isobutyl group or a sec-butyl group. Z represents an atomic group necessary for forming a cyclic hydrocarbon together with the carbon atom.

R₁₂ to R₁₆ each independently represents a linear or branched alkyl group having a carbon number of 1 to 4, or a hydrocarbon group, provided that at least one of R₁₂ to R₁₄ or either R₁₅ or R₁₆ represents a cyclic hydrocarbon.

R₁₇ to R₂₁ each independently represents a hydrogen atom, a linear or branched alkyl group having a carbon number of 1 to 4, or a cyclic hydrocarbon, provided that at least one of R₁₇ to R₂₁ represents a cyclic hydrocarbon. Also, either R₁₉ or R₂₁ represents a linear or branched alkyl group having a carbon number of 1 to 4, or a cyclic hydrocarbon.

R₂₂ to R₂₅ each independently represents a hydrogen atom, a linear or branched hydrocarbon group having a carbon number of 1 to 4, or a cyclic hydrocarbon, provided that at least one of R₂₂ to R₂₅ represents a cyclic hydrocarbon. R₂₃ and R₂₄ may combine with each other to form a ring.

In formulae (pI) to (pVI), the alkyl group in R₁₂ to R₂₅ is a linear or branched alkyl group having a carbon number of 1 to 4, which may be substituted or unsubstituted, and examples of the alkyl group include a methyl group, an ethyl group, an n-propyl group, an isopropyl group, an n-butyl group, an isobutyl group, a sec-butyl group and a tert-butyl group.

Examples of the substituent which the alkyl group may further have include an alkoxy group having a carbon number of 1 to 4, a halogen atom (fluorine, chlorine, bromine, iodine), an acyl group, an acyloxy group, a cyano group, a hydroxyl group, a carboxy group, an alkoxycarbonyl group and a nitro group.

The cyclic hydrocarbon in R₁₁ to R₂₅ and the cyclic hydrocarbon formed by Z together with the carbon atom are preferably an alicyclic hydrocarbon group and may be either monocyclic or polycyclic. Specific examples thereof include a group containing a monocyclo, bicyclo, tricyclo or tetracyclo structure having a carbon number of 5 or more. The carbon number thereof is preferably from 6 to 30, more preferably from 7 to 25. These cyclic hydrocarbons each may have a substituent.

Structural examples of the cyclic hydrocarbon moiety in the cyclic hydrocarbon are set forth below.

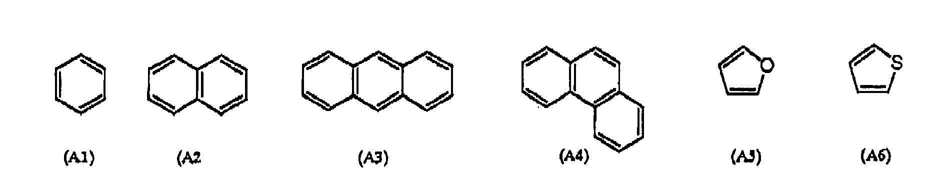

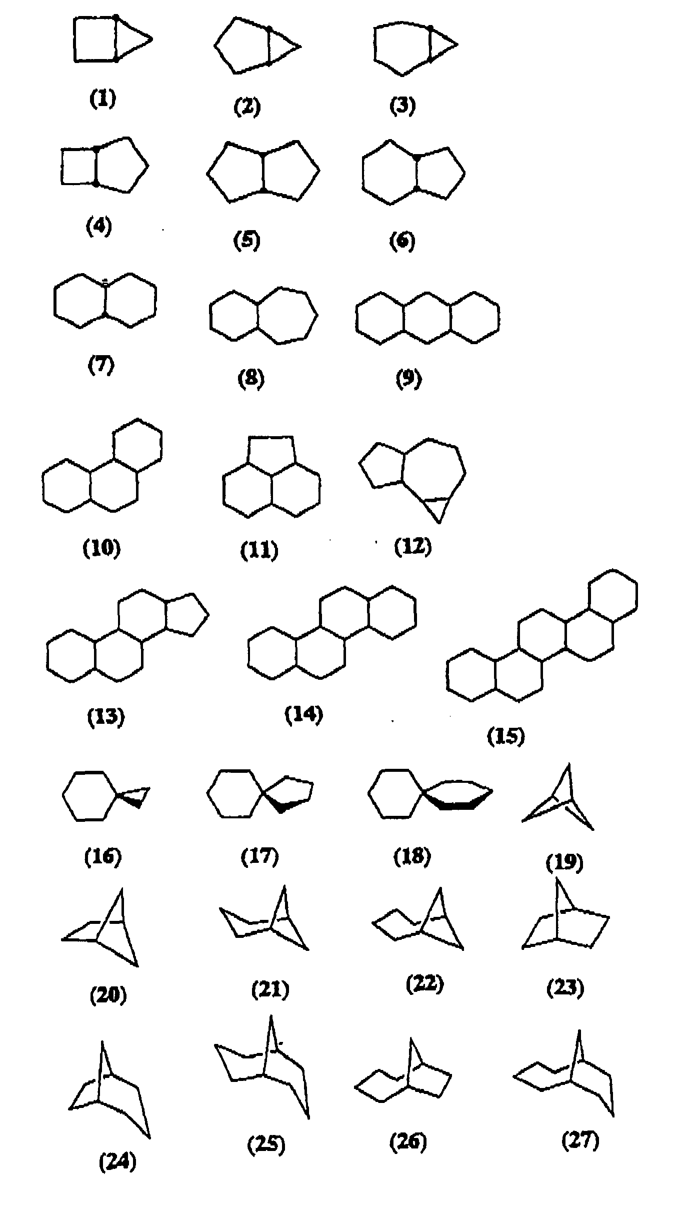

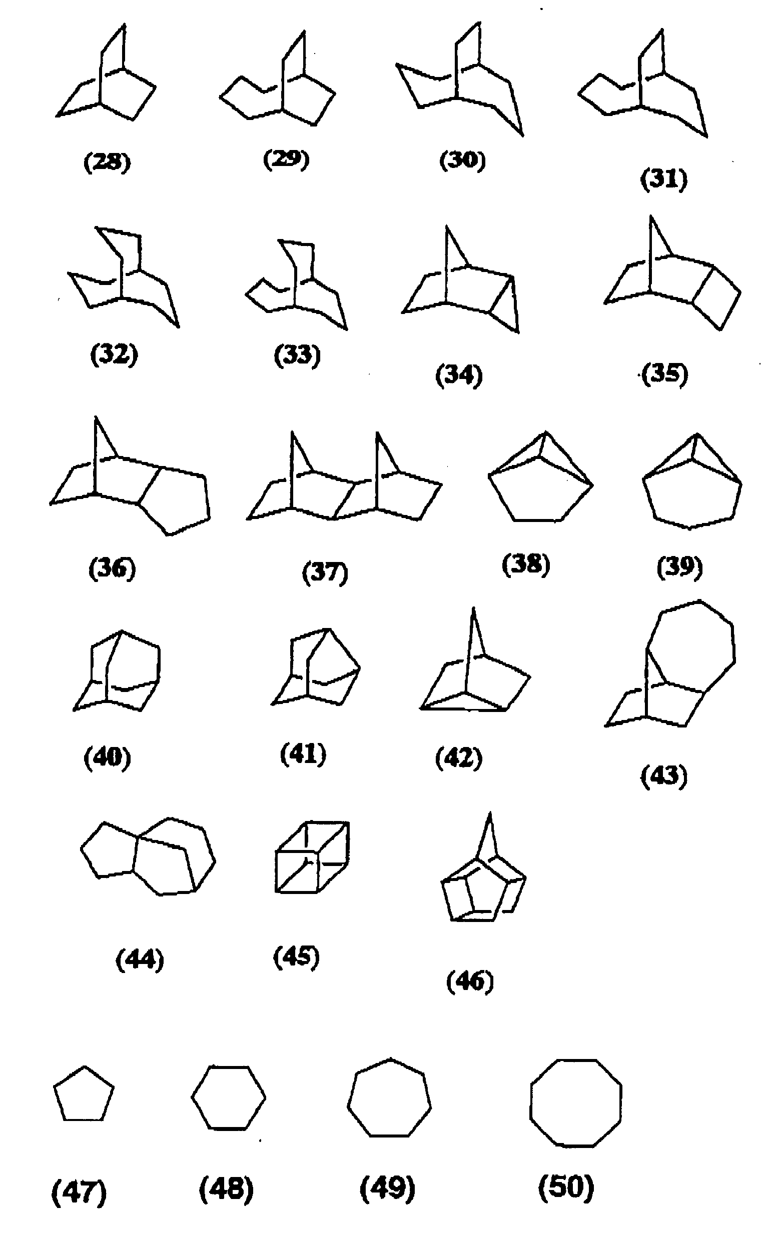

Among these cyclic hydrocarbon moieties, preferred in the present invention are an adamantyl group, a noradamantyl group, a decalin residue, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group, more preferred are an adamantyl group, a decalin residue, a norbornyl group, a cedrol group, a cyclohexyl group, a cycloheptyl group, a cyclooctyl group, a cyclodecanyl group and a cyclododecanyl group.

Examples of the substituent for these cyclic hydrocarbon groups include an alkyl group, a halogen atom, a hydroxyl group, an alkoxy group, a carboxyl group and an alkoxycarbonyl group. The alkyl group is preferably a lower alkyl group such as methyl group, ethyl group, propyl group, isopropyl group and butyl group, more preferably a methyl group, an ethyl group, a propyl group or an isopropyl group. The alkoxy group includes an alkoxy group having a carbon number of 1 to 4, such as methoxy group, ethoxy group, propoxy group and butoxy group. The alkyl group and alkoxy group each may further have a substituent. The substituent which the alkyl group and alkoxy group each may further have includes a hydroxyl group, a halogen atom and an alkoxy group.

In particular, X is preferably a group represented by formula (3):

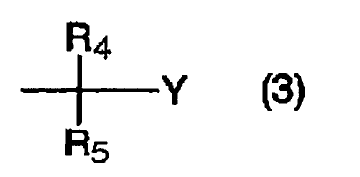

In the formula, R₄ and R₅ each independently represents an alkyl group, and Y represents an alicyclic hydrocarbon group.

The group represented by formula (3) includes a group where one of R₁₂ to R₁₉ in formula (pII) is an alicyclic hydrocarbon group.

Specific examples of the repeating unit represented by formula (1) or the monomer corresponding thereto are set forth below.

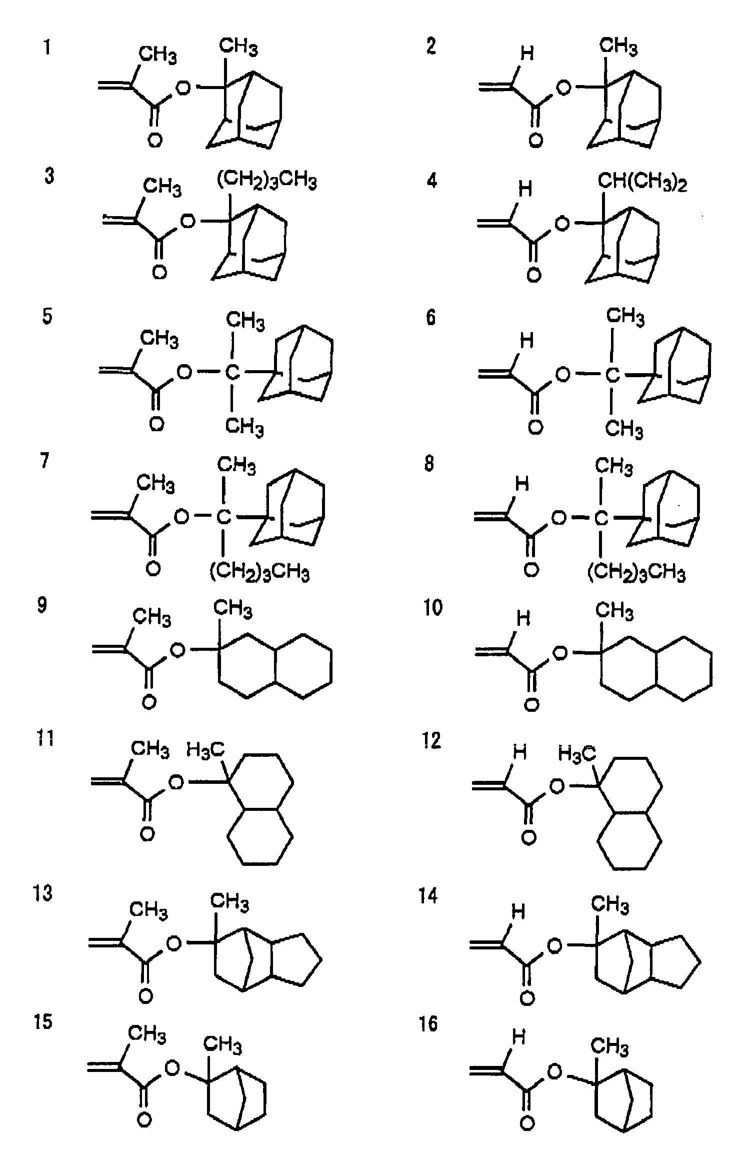

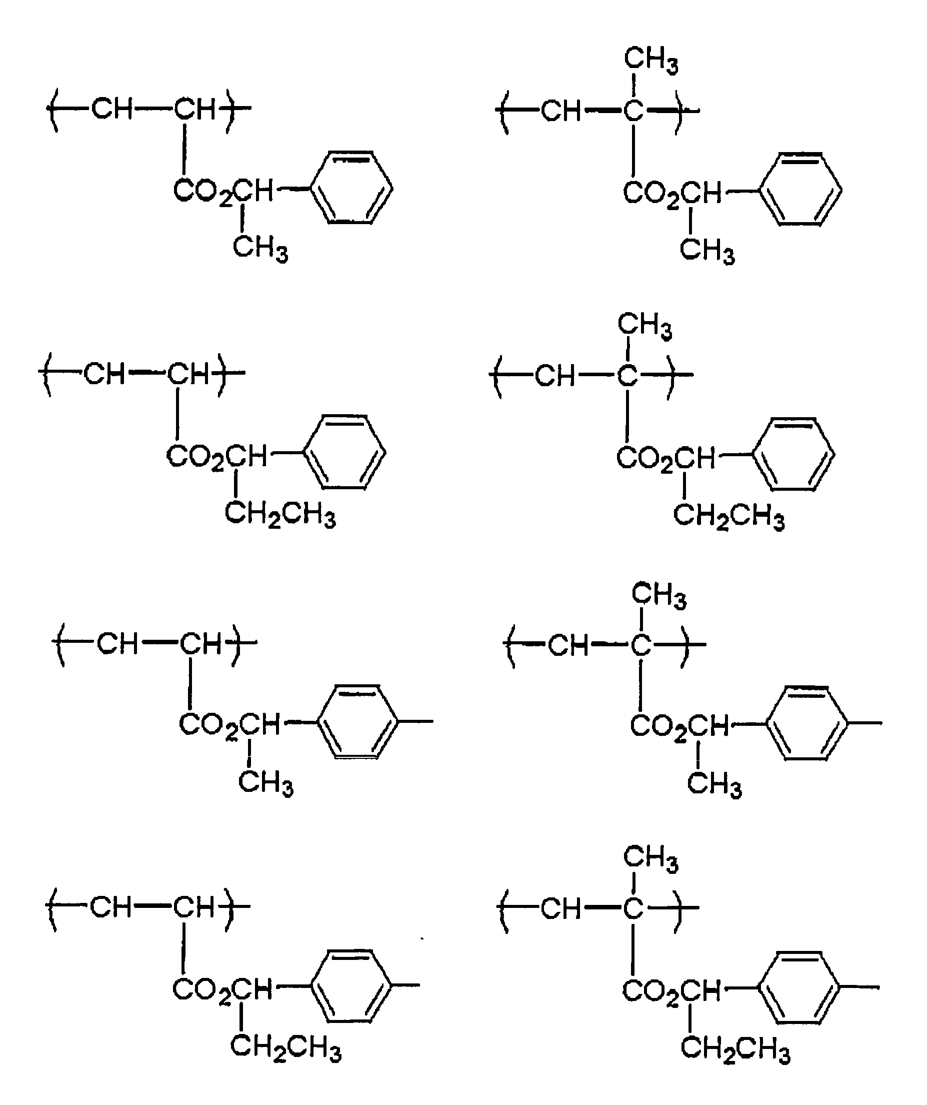

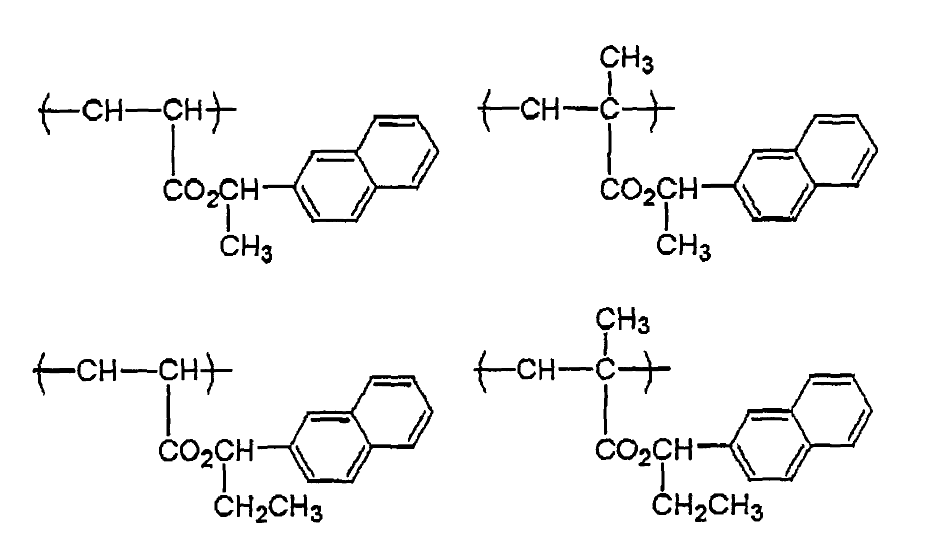

Examples of the monovalent organic group of R₃ includes an alkyl group, an aryl group and an aralkyl group. These groups each allows intervention of a heteroatom, and examples of such a group include an acyl group, an aryloxy group, an aralkyloxy group, an acyloxy group, a thioalkyl group and a thioester group. These groups each may further have a substituent.

The alkyl group as R₃ may have a substituent and is, for example, an alkyl group having a carbon number of 1 to 8, and specific preferred examples thereof include a methyl group, an ethyl group, a propyl group, an n-butyl group, a sec-butyl group, a hexyl group and an octyl group.

The alkoxy group as R₃ may have a substituent and is, for example, an alkoxy group having a carbon number of 1 to 8, and examples thereof include a methoxy group, an ethoxy group, a propoxy group, a butoxy group, a pentyloxy group, a hexyloxy group and a cyclohexyloxy group.

The aryl group as R₃ may have a substituent and is, for example, an aryl group having a carbon number of 6 to 15, and specific preferred examples thereof include a phenyl group, a tolyl group, a naphthyl group and an anthryl group.

The acyl group as R₃ may have a substituent and is, for example, an acyl group having a carbon number of 2 to 8, and specific preferred examples thereof include a formyl group, an acetyl group, a propanoyl group, a butanoyl group, a pivaloyl group and a benzoyl group.

Examples of the substituent which these groups each may have include a hydroxyl group, a carboxyl group, a halogen atom (e.g., fluorine, chlorine, bromine, iodine), and an alkoxy group (e.g., methoxy, ethoxy, propoxy, butoxy).

In formula (2), the OH group may be present at any position on the benzene ring but is preferably present at the meta- or para-position of the styrene skeleton, more preferably at the para-position.

Specific examples of the repeating unit represented by formula (2) are set forth below, but the present invention is not limited thereto.

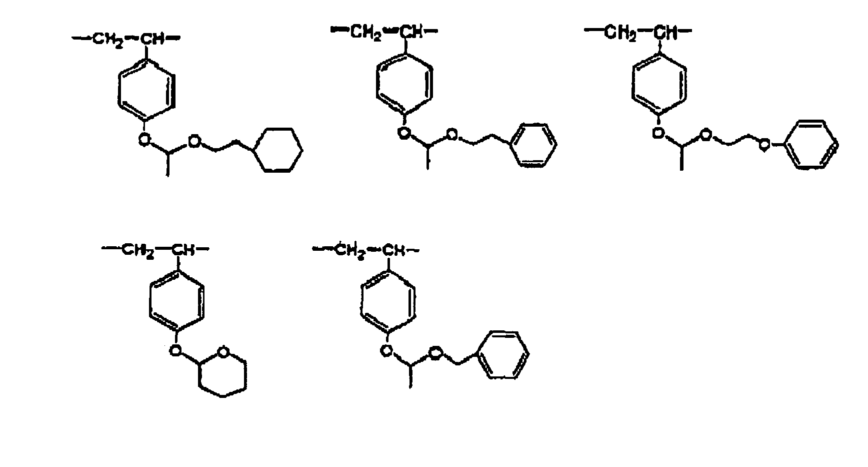

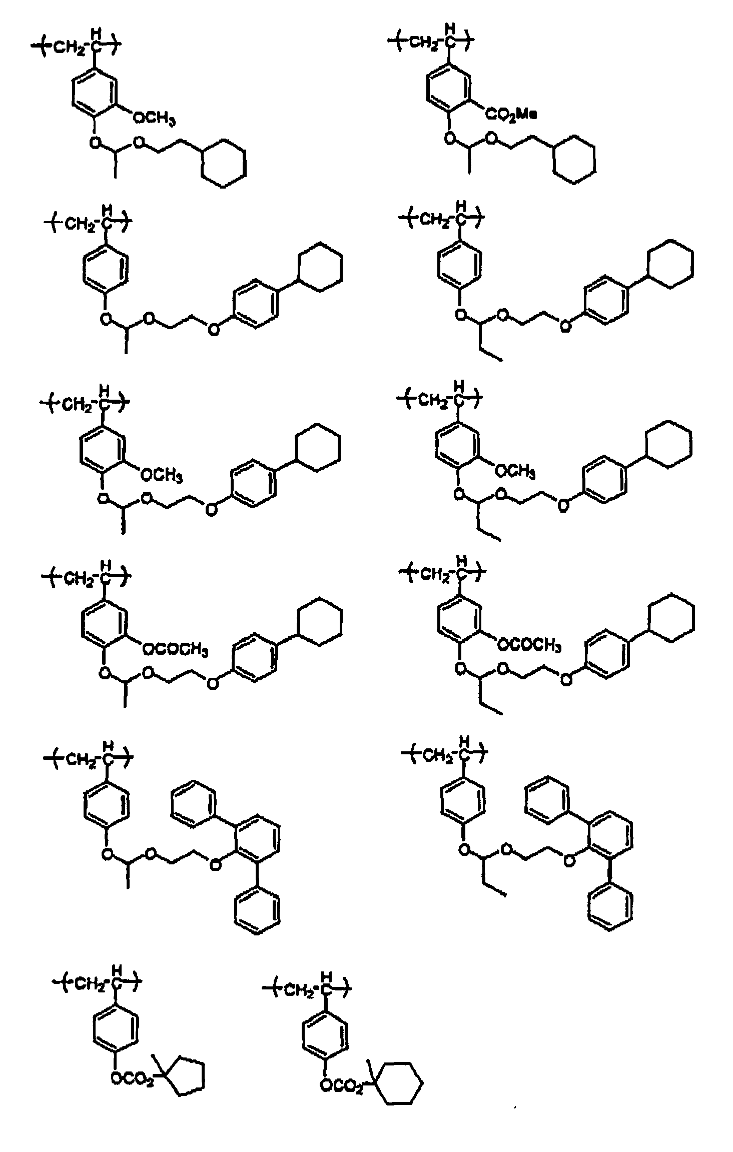

The resin (A) preferably further contains a cyclic hydrocarbon structure-containing repeating unit which is alkali-insoluble and inert to an acid. By virtue of this construction, the dissolution contrast and diffusion of the acid generated from the acid generator can be easily controlled.

In the present invention, the term "inert to an acid" means to cause substantially no chemical reaction with the acid generated from the acid generator.

It is also preferred that the resin (A) further has a repeating unit represented by formula (A4):

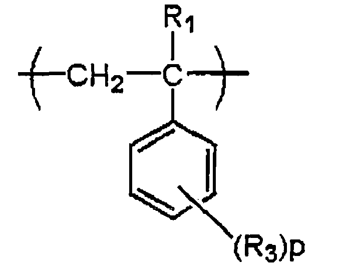

In formula (A4), R₁ represents a hydrogen atom, a halogen atom, an alkyl group, or a cyano group.

R₃ represents a monovalent organic group not having a property of decomposing under the action of an acid, or represents a hydrogen atom, a halogen atom, or a nitro group.

p represents an integer of 0 to 5 and when p is an integer of 2 or more, the plurality of R₃'s may be the same or different.

Specific examples of the group incapable of decomposing under the action of an acid (sometimes referred to as an acid-stable group) include a cycloalkyl group, an alkenyl group, a cycloalkyloxy group, an alkenyloxy group, an aryloxy group, an alkylcarbonyloxy group, an alkylamidomethyloxy group, an alkylamide group, an arylamidomethyl group and an arylamide group. The acid-stable group is preferably a cycloalkyl group, an alkylcarbonyloxy group, a cycloalkyloxy group, an aryloxy group, an alkylamideoxy group or an alkylamide group, more preferably a cycloalkyl group, an alkylcarbonyloxy group, a cycloalkyloxy group or an aryloxy group. In the acid-stable group, the cycloalkyl group is preferably a cycloalkyl group having a carbon number of 3 to 10, such as cyclopropyl group, cyclobutyl group, cyclohexyl group and adamantyl group, and the alkenyl group is preferably an alkenyl group having a carbon number of 2 to 4, such as vinyl group, propenyl group, allyl group and butenyl group.

R₃ is preferably a hydrogen atom.

Specific examples of the repeating unit represented by formula (A4) are set forth below, but the present invention is not limited thereto.

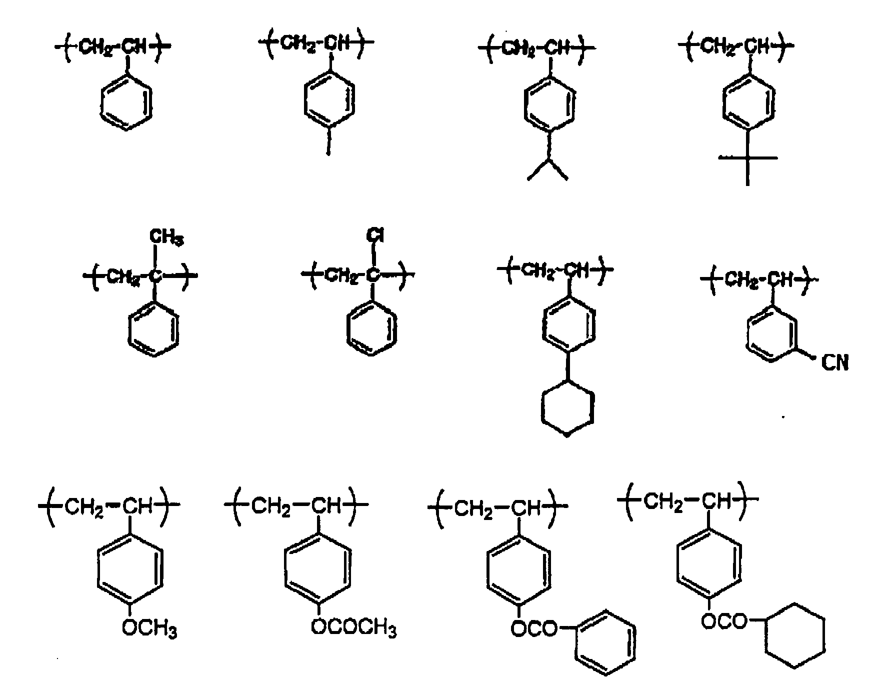

The content of the repeating unit represented by formula (1) in the resin (A) is preferably from 3 to 80 mol%, more preferably from 5 to 70 mol%, still more preferably from 5 to 50 mol%, based on all repeating units. The content is preferably 3 mol% or more for unfailingly preventing film loss in the unexposed area or reduction of the resolving power, and is preferably 80 mol% or less in view of adhesion to the substrate or prevention of scumming.

The content of the repeating unit represented by formula (2) in the resin (A) is preferably from 20 to 97 mol%, more preferably from 30 to 95 mol%, still more preferably from 50 to 95 mol%, based on all repeating units. The content is preferably 20% or more from the standpoint of preventing adhesion failure to the substrate or scumming, and is preferably 97 mol% or less for unfailingly preventing film loss in the unexposed area or reduction of the resolving power.

The resin (A) may further has a repeating unit represented by formula (4), and this is preferred from the standpoint of, for example, enhancing the film quality or reducing film loss in the unexposed area. The content of the repeating unit represented by formula (4) is preferably from 0 to 50 mol%, more preferably from 1 to 40 mol%, still more preferably from 3 to 30 mol%, based on all repeating units.

In the resin (A), for maintaining good developability with an alkali developer, another appropriate polymerizable monomer may be copolymerized so that an alkali-soluble group such as phenolic hydroxyl group or carboxyl group can be introduced, or for enhancing the film quality, another hydrophobic polymerizable monomer such as alkyl acrylate and alkyl methacrylate may be copolymerized.

Furthermore, the resin (A) may contain a monomer having an acid-decomposable group other than the acid-decomposable group contained in formula (1), and examples of the other acid-decomposable group include a group represented by -C(=O)-X₁-R₀.

In the formula above, R₀ represents, for example, a tertiary alkyl group such as tert-butyl group and tert-amyl group, an isobornyl group, a 1-alkoxyethyl group such as 1-ethoxyethyl group, 1-butoxyethyl group, 1-isobutoxyethyl group and 1-cyclohexyloxyethyl group, an alkoxymethyl group such as 1-methoxymethyl group and 1-ethoxyrnethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group, or a mevalonic lactone residue. X₁ represents an oxygen atom, a sulfur atom, -NH-, -NHSO₂-, or -NHSO₂NH-.

Incidentally, when the resin of the present invention contains a repeating unit having an action of suppressing the main chain movement by the hydrogen bonding interaction or structural rigidity, the resin of the present invention can be more easily obtained. Specifically, the resin of the present invention preferably contains a monomer having a strong hydrogen bonding interaction moiety in the side chain (for example, a monomer having a (meth)acrylamide structure or a maleimide structure), or a monomer having a structure where the carbon-carbon double bond participating in the polymerization is cyclized (for example, a monomer having an indene structure).

The weight average molecular weight (Mw) of the resin (A) is from 1,500 to 3,500, preferably from 2,000 to 3,000, in view of dissolution contrast, prevention of film loss in the unexposed area, dissolution rate of the resin itself in alkali. The dispersity (Mw/Mn) is preferably 1.5 or less, more preferably 1.4 or less, still more preferably 1.3 or less.

The weight average molecular weight here is defined as a polystyrene-reduced value determined by gel permeation chromatography.

The glass transition temperature (Tg) of the resin (A) is preferably from 100 to 150°C, more preferably from 100 to 130°C, still more preferably from 100 to 110°C.

The resins (A) each may be used in combination of two or more kinds thereof.

The amount of the resin (A) added is, as the total amount, usually from 10 to 96 mass%, preferably from 15 to 96 mass%, more preferably from 20 to 95 mass%, based on the entire solid content of the positive resist composition. (In this specification, mass ratio is equal to weight ratio.)

The polymer for use in the present invention may be polymerized by using any method of radical polymerization, anionic polymerization or cationic polymerization, but from the standpoint of controlling the copolymerization reaction, a radical polymerization method is preferred. Furthermore, from the standpoint of controlling the molecular weight and molecular weight distribution, a living radical polymerization method is more preferred. Specific examples thereof include a method of using a compound selected from a nitroxide compound, an atom-transfer polymerization system and a RAFT agent, and a radical polymerization initiator (azo-based or peroxide-based) in combination. The acid-decomposable protective group may be introduced by either a method of copolymerizing a monomer having an acid-decomposable protective group, or a method of introducing a protective group into a resin having an alkali-soluble hydroxyl group such as phenolic hydroxyl group or a carboxyl group.

Specific examples of the resin (A) are set forth below, but the present invention is not limited thereto.

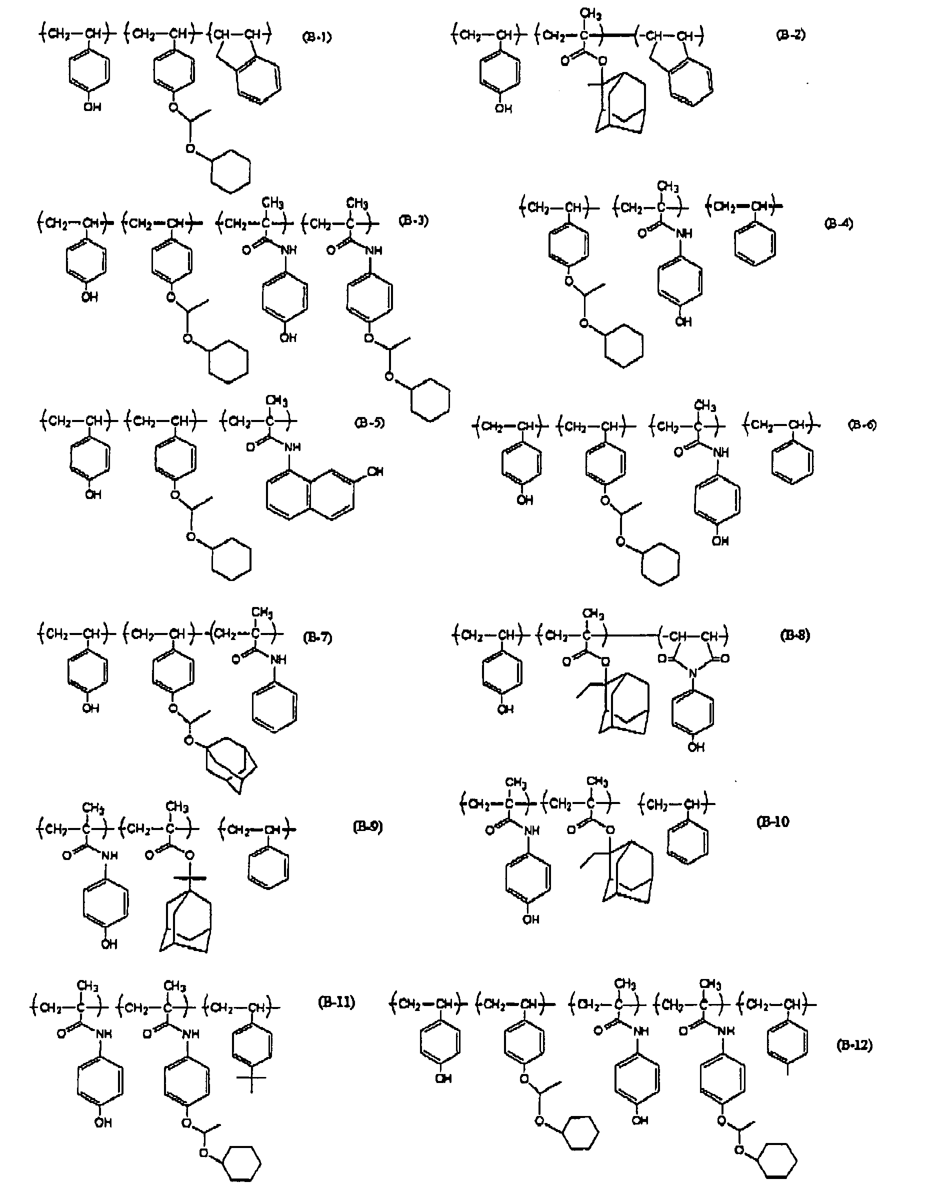

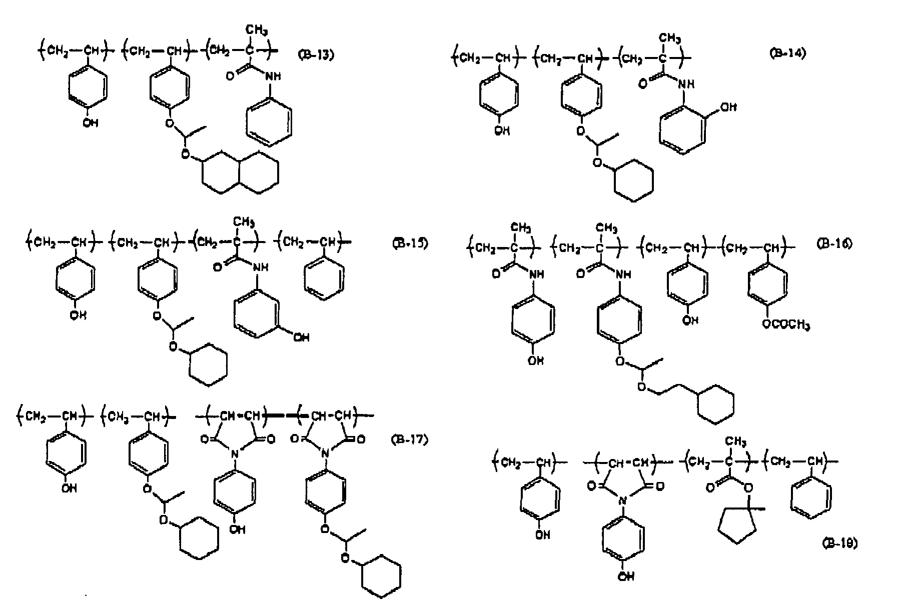

### [2] (B) Compound capable of generating a sulfonic acid upon irradiation with actinic rays or radiation

The resist composition of the present invention contains, as the compound capable of generating an acid upon irradiation with actinic rays or radiation (acid generator), a compound capable of generating a sulfonic acid upon irradiation with actinic rays or radiation, preferably further contains a compound capable of generating a carboxylic acid upon irradiation with actinic rays or radiation. Compound capable of generating an acid upon irradiation with actinic rays or radiation (hereinafter sometimes referred to as an "acid generator" or a "component (B)") contained in the positive resist composition of the present invention:
The photoresist composition of the present invention contains a compound capable of generating an acid upon irradiation with actinic rays or radiation.
The photoacid generator which can be used may be appropriately selected from a photoinitiator for photo-cationic polymerization, a photoinitiator for photoradical polymerization, a photo-decoloring agent for coloring matters, a photo-discoloring agent, a compound known to generate an acid upon irradiation with actinic rays or radiation and used for microresist or the like, and a mixture thereof.

Examples thereof include a diazonium salt, a phosphonium salt, a sulfonium salt, an iodonium salt, an imidosulfonate, an oxime sulfonate, a diazodisulfone, a disulfone and an o-nitrobenzyl sulfonate.

Also, a compound where such a group or compound capable of generating an acid upon irradiation with actinic rays or radiation is introduced into the main or side chain of the polymer, for example, compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029, may be used.

Furthermore, compounds capable of generating an acid by the effect of light described, for example, in U.S. Patent 3,779,778 and European Patent 126,712 may also be used.

Out of the compounds capable of generating an acid by decomposition upon irradiation with actinic rays or radiation, the compounds represented by the following formulae (ZI), (ZII) and (ZIII) are preferred.

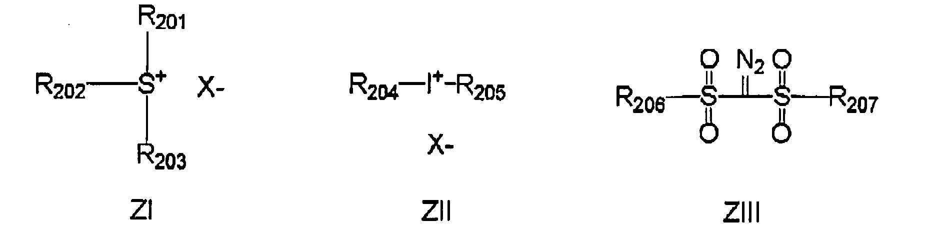

In above formula (ZI), R₂₀₁, R₂₀₂ and R₂₀₃ each independently represents an organic group.

X⁻ represents a non-nucleophilic anion, and preferred examples thereof include sulfonate anion, carboxylate anion, bis(alkylsulfonyl)amide anion, tris(alkylsulfonyl)methide anion, BF₄⁻, PF₆⁻ and SbF₆⁻. The anion is preferably an organic anion containing a carbon atom.

The preferred organic anion includes the organic anions represented by the following formulae AN1 to AN4:

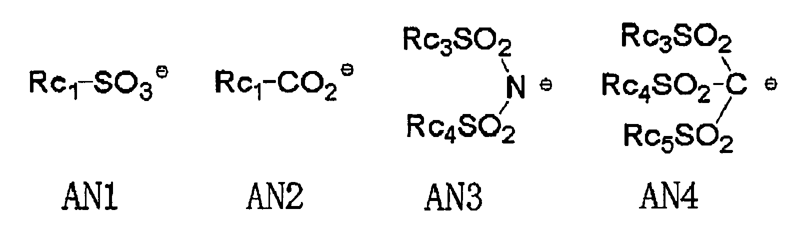

In the formulae, Rc₁ represents an organic group.

The organic group in Rc₁ includes an organic group having a carbon number of 1 to 30 and is preferably an alkyl or aryl group which may be substituted, or a group where a plurality of these groups are connected through a single bond or a linking group such as -O- -CO₂-, -S-, -SO₃- and -SO₂N(Rd₁)-. Rd₁ represents a hydrogen atom or an alkyl group and may form a ring structure with the alkyl or aryl group to which Rd₁ is bonded.

The organic group of Rc₁ is more preferably an alkyl group substituted by a fluorine atom or a fluoroalkyl group at the 1-position, or a phenyl group substituted by a fluorine atom or a fluoroalkyl group. By virtue of having a fluorine atom or a fluoroalkyl group, the acidity of the acid generated upon irradiation with light increases and the sensitivity is enhanced. When Rc₁ has 5 or more carbon atoms, at least one carbon atom is preferably substituted by a hydrogen atom, and it is more preferred that the number of hydrogen atoms is larger than the number of fluorine atoms. The absence of a perfluoroalkyl group having a carbon number of 5 or more enables reduction in the toxicity to ecology.

In a most preferred embodiment, Rc₁ is a group represented by the following formula.

RC₇-Ax-Rc₆-

In the formula, Rc₆ represents a perfluoroalkylene group having a carbon number of 4 or less, preferably from 2 to 4, more preferably 2 or 3, or a phenylene group substituted by from 1 to 4 fluorine atoms and/or from 1 to 3 fluoroalkyl groups,

Ax represents a linking group (preferably a single bond, -O-, -CO₂-, -S-, -SO₃- or -SO₂N(Rd₁)-). Rd₁ represents a hydrogen atom or an alkyl group and may combine with Rc₇ to form a ring structure. Rc₇ represents a hydrogen atom, a fluorine atom, a linear or branched, monocyclic or polycyclic alkyl group which may be substituted, or an aryl group which may be substituted. The alkyl group and aryl group, which each may be substituted, preferably contain no fluorine atom as the substituent.

Rc₃, Rc₄ and Rc₅ each independently represents an organic group. Preferred organic groups for Rc₃, Rc₄ and Rc₅ are the same as preferred organic groups in Rc₁.

Rc₃ and Rc₄ may combine to form a ring.

The group formed by combining Rc₃ and Rc₄ includes an alkylene group and an arylene group and is preferably a perfluoroalkylene group having a carbon number of 2 to 4. When Rc₃ and Rc₄ combine to form a ring, this is preferred because the acidity of the acid generated upon irradiation with light increases and the sensitivity is enhanced.

The carbon number of the organic group as R₂₀₁, R₂₀₂ and R₂₀₃ is generally from 1 to 30, preferably from 1 to 20.

Two members out of R₂₀₁ to R₂₀₃ may combine to form a ring structure, and the ring may contain an oxygen atom, a sulfur atom, an ester bond, an amide bond or a carbonyl group.

Examples of the group formed by combining two members out of R₂₀₁ to R₂₀₃ include an alkylene group (e.g., butylene, pentylene).

Specific examples of the organic group as R₂₀₁, R₂₀₂ and R₂₀₃ include corresponding groups in the compounds (ZI-1), (ZI-2) and (ZI-3) which are described later.

The compound may be a compound having a plurality of structures represented by formula (ZI). For example, the compound may be a compound having a structure that at least one of R₂₀₁ to R₂₀₃ in the compound represented by formula (ZI) is bonded to at least one of R₂₀₁ to R₂₀₃ in another compound represented by formula (ZI).

The component (ZI) is more preferably a compound (ZI-1), (ZI-2) or (ZI-3) described below.

The compound (ZI-1) is an arylsulfonium compound where at least one of R₂₀₁ to R₂₀₃ in formula (ZI) is an aryl group, that is, a compound having an arylsulfonium as the cation.

In the arylsulfonium compound, R₂₀₁ to R₂₀₃ all may be an aryl group or a part of R₂₀₁ to R₂₀₃ may be an aryl group with the remaining being an alkyl group.

Examples of the arylsulfonium compound include a triarylsulfonium compound, a diarylalkylsulfonium compound, and an aryldialkylsulfonium compound.

The aryl group in the arylsulfonium compound is preferably an aryl group such as phenyl group and naphthyl group, or a heteroaryl group such as indole residue and pyrrole residue, more preferably a phenyl group or an indole residue. In the case where the arylsulfonium compound has two or more aryl groups, these two or more aryl groups may be the same or different.

The alkyl group which is present, if desired, in the arylsulfonium compound is preferably a linear, branched or cyclic alkyl group having a carbon number of 1 to 15, and examples thereof include a methyl group, an ethyl group, a propyl group, an n-butyl group, a sec-butyl group, a tert-butyl group, a cyclopropyl group, a cyclobutyl group, and a cyclohexyl group.

The aryl group and alkyl group of R₂₀₁ to R₂₀₃ each may have, as the substituent, an alkyl group (for example, an alkyl group having a carbon number of 1 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear, branched or cyclic alkyl group having a carbon number of 1 to 12, or a linear, branched or cyclic alkoxy group having a carbon number of 1 to 12, and most preferably an alkyl group having a carbon number of 1 to 4 or an alkoxy group having a carbon number of 1 to 4. The substituent may be substituted to any one of three members R₂₀₁ to R₂₀₃ or may be substituted to all of these three members. In the case where R₂₀₁ to R₂₀₃ are an aryl group, the substituent is preferably substituted at the p-position of the aryl group.

The compound (ZI-2) is described below.

The compound (ZI-2) is a compound where R₂₀₁ to R₂₀₃ in formula (ZI) each independently represents an aromatic ring-free organic group. The aromatic ring as used herein includes an aromatic ring containing a heteroatom.

The aromatic ring-free organic group as R₂₀₁ to R₂₀₃ generally has a carbon number of 1 to 30, preferably from 1 to 20.

R₂₀₁ to R₂₀₃ each is independently preferably an alkyl group, a 2-oxoalkyl group, an alkoxycarbonylmethyl group, or a vinyl group, more preferably a linear, branched or cyclic 2-oxoalkyl group or an alkoxycarbonylmethyl group, and most preferably a linear or branched 2-oxoalkyl group.

The alkyl group as R₂₀₁ to R₂₀₃ may be linear, branched or cyclic and is preferably a linear or branched alkyl group having a carbon number of 1 to 10 (e.g., methyl, ethyl, propyl, butyl, pentyl), or a cyclic alkyl group having a carbon number of 3 to 10 (e.g., cyclopentyl, cyclohexyl, norbornyl).

The 2-oxoalkyl group as R₂₀₁ to R₂₀₃ may be linear, branched or cyclic and is preferably a group having >C=O at the 2-position of the above-described alkyl group.

The alkoxy group in the alkoxycarbonylmethyl group as R₂₀₁ to R₂₀₃ is preferably an alkoxy group having a carbon number of 1 to 5 (e.g., methoxy, ethoxy, propoxy, butoxy, pentoxy).

R₂₀₁ to R₂₀₃ each may be further substituted by a halogen atom, an alkoxy group (for example, an alkoxy group having a carbon number of 1 to 5), a hydroxyl group, a cyano group or a nitro group.

Two members out of R₂₀₁ to R₂₀₃ may combine to form a ring structure, and the ring may contain an oxygen atom, a sulfur atom, an ester bond, an amide bond or a carbonyl group. Examples of the group formed by combining two members out of R₂₀₁ to R₂₀₃ include an alkylene group (e. g. , butylene, pentylene).

The compound (ZI-3) is a compound represented by the following formula (ZI-3), and this is a compound having a phenacylsulfonium salt structure.

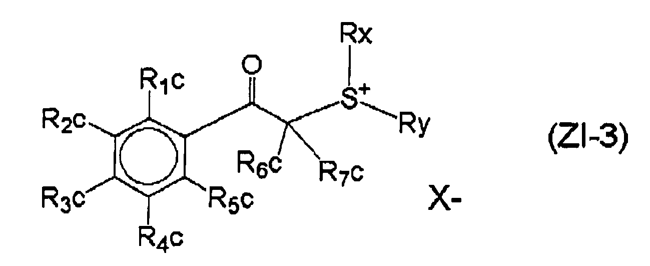

In the formula, R_{1c} to R_{5c} each independently represents a hydrogen atom, an alkyl group, an alkoxy group, or a halogen atom.

R_{6c} and R_{7c} each independently represents a hydrogen atom or an alkyl group.

Rₓ and R_{y} each independently represents an alkyl group, a 2-oxoalkyl group, an alkoxycarbonylmethyl group, an allyl group or a vinyl group.

Any two or more members out of R_{1c} to R_{5c} or a pair of Rₓ and R_{y} may combine with each other to form a ring structure, and the ring structure may contain an oxygen atom, a sulfur atom, an ester bond or an amide bond.

The alkyl group as R_{1c} to R_{5c} may be linear, branched or cyclic and is, for example, an alkyl group having a carbon number of 1 to 20, preferably a linear or branched alkyl group having a carbon number of 1 to 12 (for example, a methyl group, an ethyl group, a linear or branched propyl group, a linear or branched butyl group, or a linear or branched pentyl group), or a cyclic alkyl group having a carbon number of 3 to 8 (e.g., cyclopentyl, cyclohexyl).

The alkoxy group as R_{1c} to R_{5c} may be linear, branched or cyclic and is, for example, an alkoxy group having a carbon number of 1 to 10, preferably a linear or branched alkoxy group having a carbon number of 1 to 5 (for example, a methoxy group, an ethoxy group, a linear or branched propoxy group, a linear or branched butoxy group, or a linear or branched pentoxy group), or a cyclic alkoxy group having a carbon number of 3 to 8 (e.g., cyclopentyloxy, cyclohexyloxy).

A compound where any one of R_{1c} to R_{5c} is a linear, branched or cyclic alkyl group or a linear, branched or cyclic alkoxy group is preferred, and a compound where the sum of carbon numbers of R_{1c} to R_{5c} is from 2 to 15 is more preferred. By virtue of this construction, the solvent solubility is more enhanced and generation of particles during storage is suppressed.

The alkyl group as Rₓ and R_{y} is the same as the alkyl group of R_{1c} to R_{5c}.

The 2-oxoalkyl group includes a group having >C=O at the 2-position of the alkyl group as R_{1c} to R_{5c}.

The alkoxy group in the alkoxycarbonylmethyl group is the same as the alkoxy group of R_{1c} to R_{5c}.

Examples of the group formed by combining Rₓ and R_{y} include a butylene group and a pentylene group.

Rₓ and R_{y} each is preferably an alkyl group having a carbon number of 4 or more, more preferably 6 or more, still more preferably 8 or more.

In formulae (ZII) and (ZIII), R₂₀₄ to R₂₀₇ each independently represents an aryl group which may have a substituent, or an alkyl group which may have a substituent.

The aryl group of R₂₀₄ to R₂₀₇ is preferably a phenyl group or a naphthyl group, more preferably a phenyl group.

The alkyl group of R₂₀₄ to R₂₀₇ may be linear, branched or cyclic and is preferably a linear or branched alkyl group having a carbon number of 1 to 10 (e.g., methyl, ethyl, propyl, butyl, pentyl), or a cyclic alkyl group having a carbon number of 3 to 10 (e.g., cyclopentyl, cyclohexyl, norbornyl).

Examples of the substituent which R₂₀₄ to R₂₀₇ each may have include an alkyl group (for example, an alkyl group having a carbon number of 1 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

X⁻ represents a non-nucleophilic anion and is the same as the non-nucleophilic anion of X⁻ in formula (I).

Out of the compounds capable of decomposing upon irradiation with actinic rays or radiation to generate an acid, preferred compounds further include the compounds represented by the following formulae (ZIV), (ZV) and (ZVI):

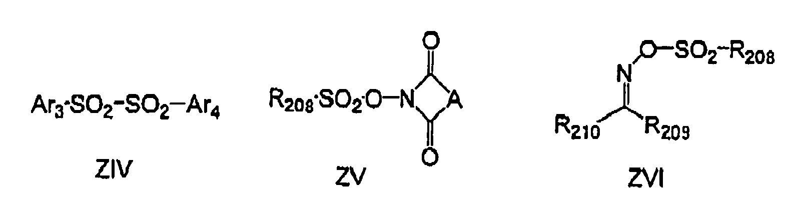

In formulae (ZIV) to (ZVI), Ar₃ and Ar₄ each independently represents a substituted or unsubstituted aryl group.

R₂₀₈ represents a substituted or unsubstituted alkyl group, or a substituted or unsubstituted aryl group.

R₂₀₉ and R₂₁₀ each independently represents a substituted or unsubstituted alkyl group, a substituted or unsubstituted aryl group, or an electron-withdrawing group. R₂₀₉ is preferably a substituted or unsubstituted aryl group.

R₂₁₀ is preferably an electron-withdrawing group, more preferably a cyano group or a fluoroalkyl group.

A represents a substituted or unsubstituted alkylene group, a substituted or unsubstituted alkenylene group, or a substituted or unsubstituted arylene group.

Among the compounds capable of decomposing upon irradiation with actinic rays or radiation to generate an acid, the compounds represented by formulae (ZI) to (ZIII) are preferred, the compound represented by formula (ZI) is more preferred, and the compounds represented by formulae (ZI-1) to (ZI-3) are most preferred.

Furthermore, the acid generator (B) is preferably a compound capable of generating an acid represented by any one of the following formulae AC1 to AC3 upon irradiation with actinic rays or radiation.

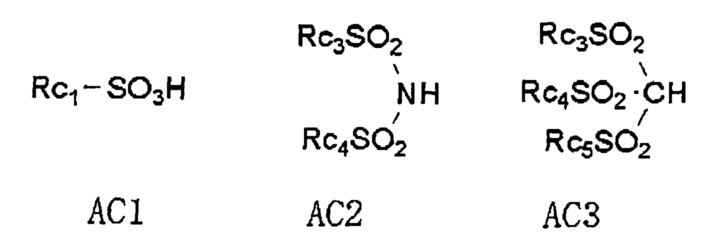

In the formulae, Rc₁ and Rc₃ to Rc₅ have the same meanings as above.

That is, a most preferred embodiment of the component (A) is a compound where in the structure of formula (ZI), X⁻ is an anion having a structure selected from AN1, AN3 and AN4.

Out of the compounds capable of decomposing upon irradiation with actinic rays or radiation to generate an acid, particularly preferred examples are set forth below.

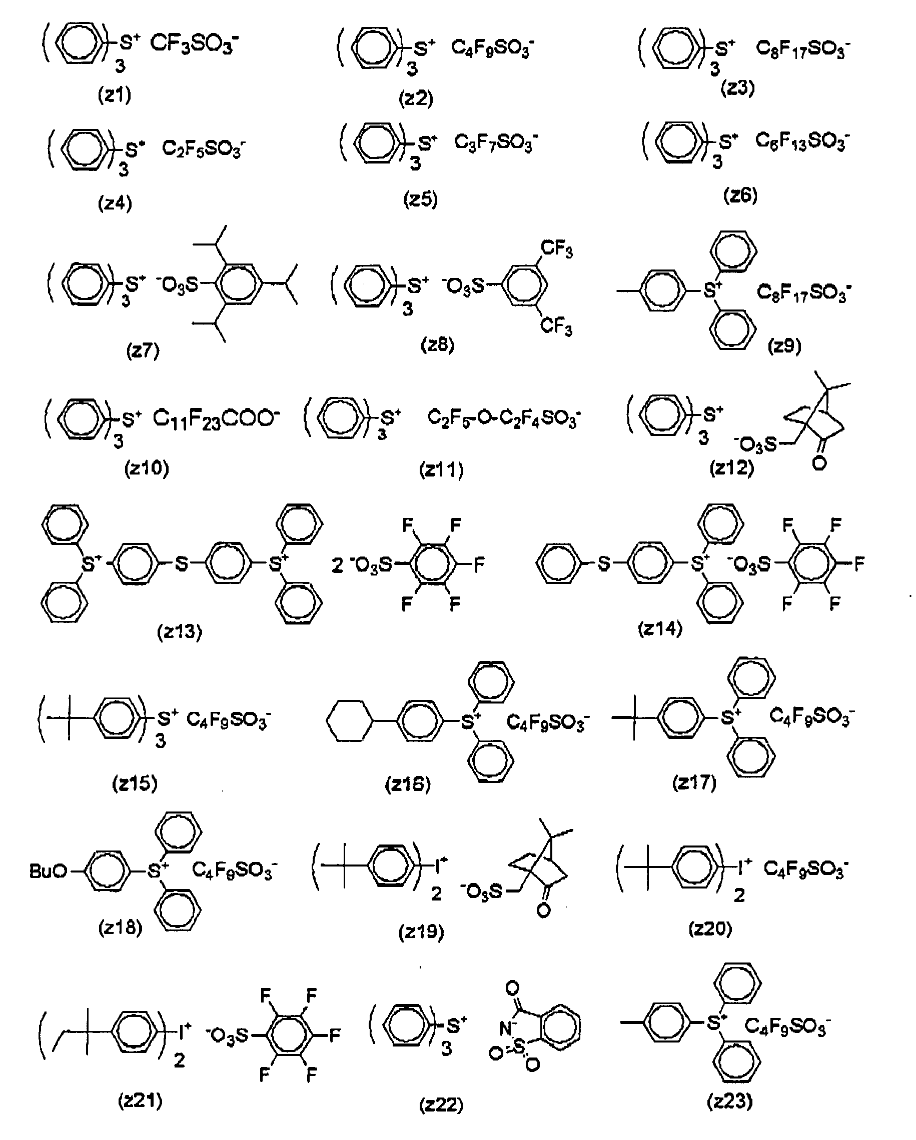

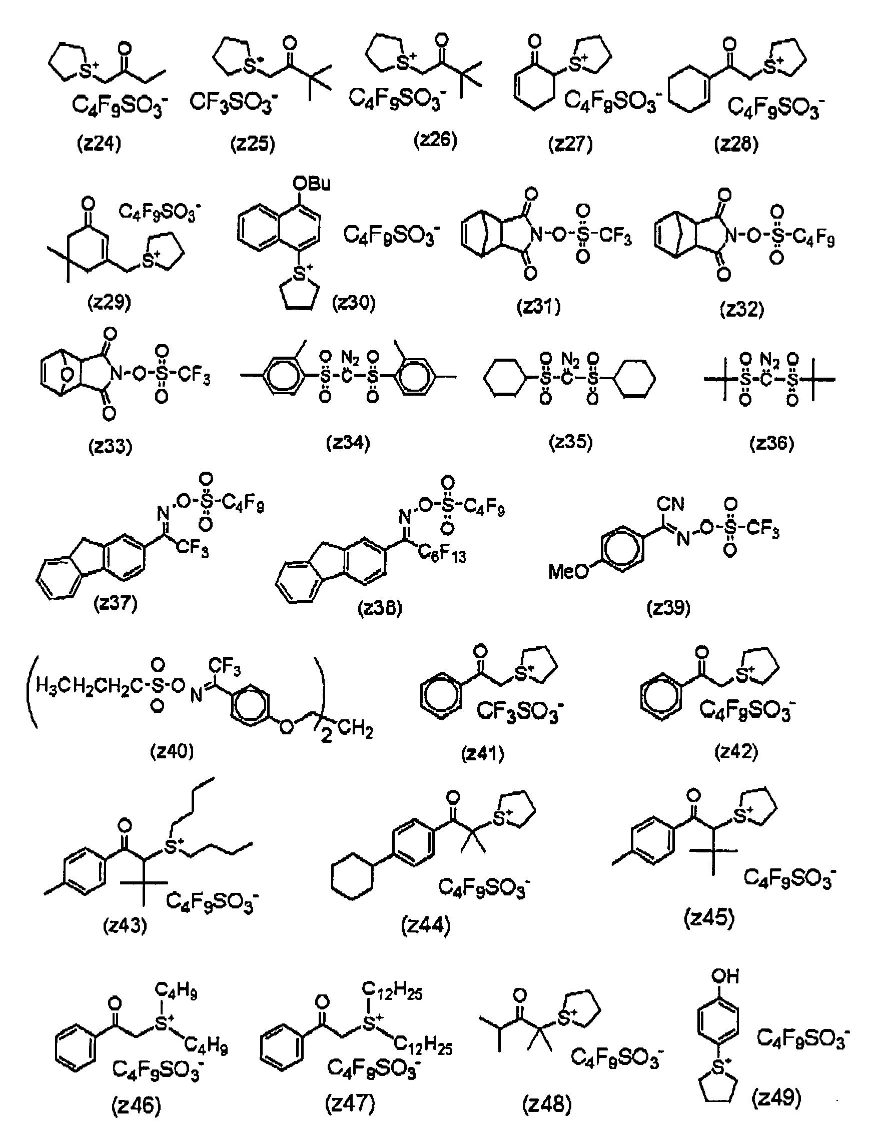

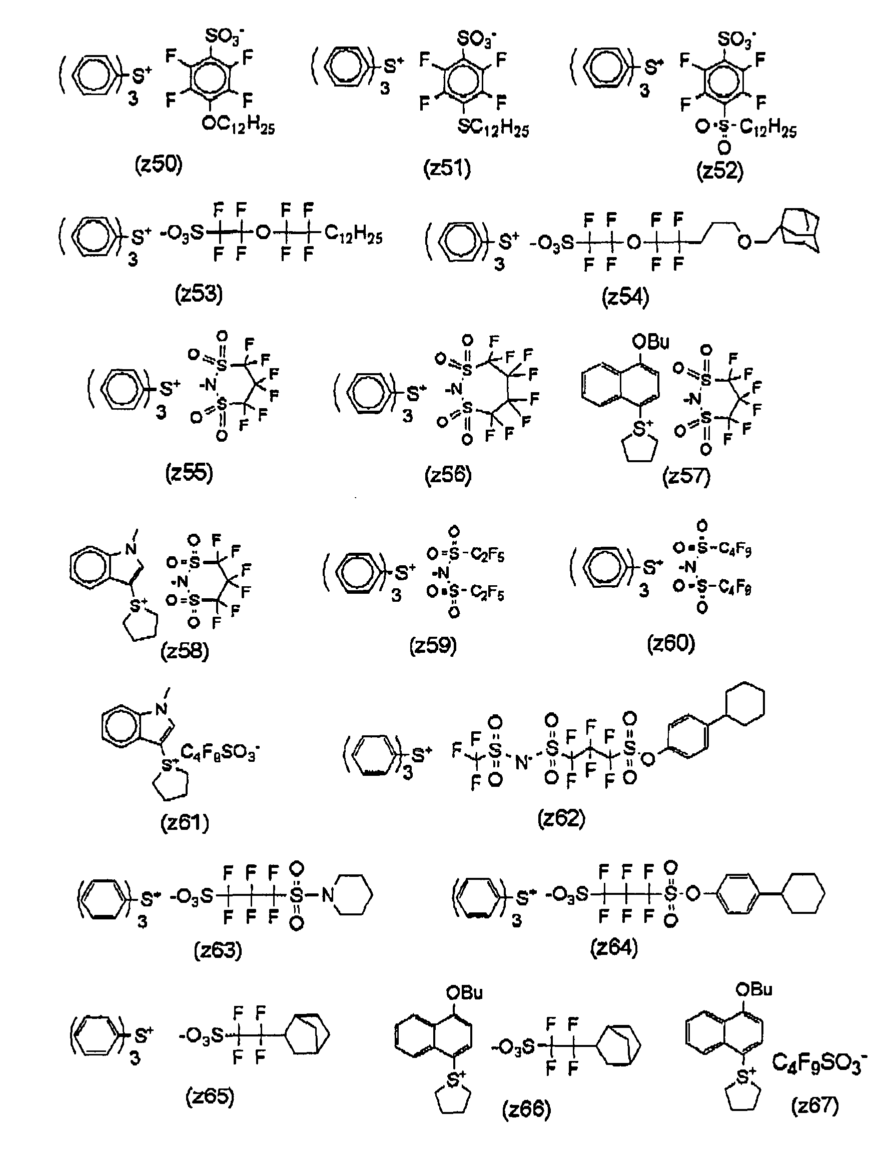

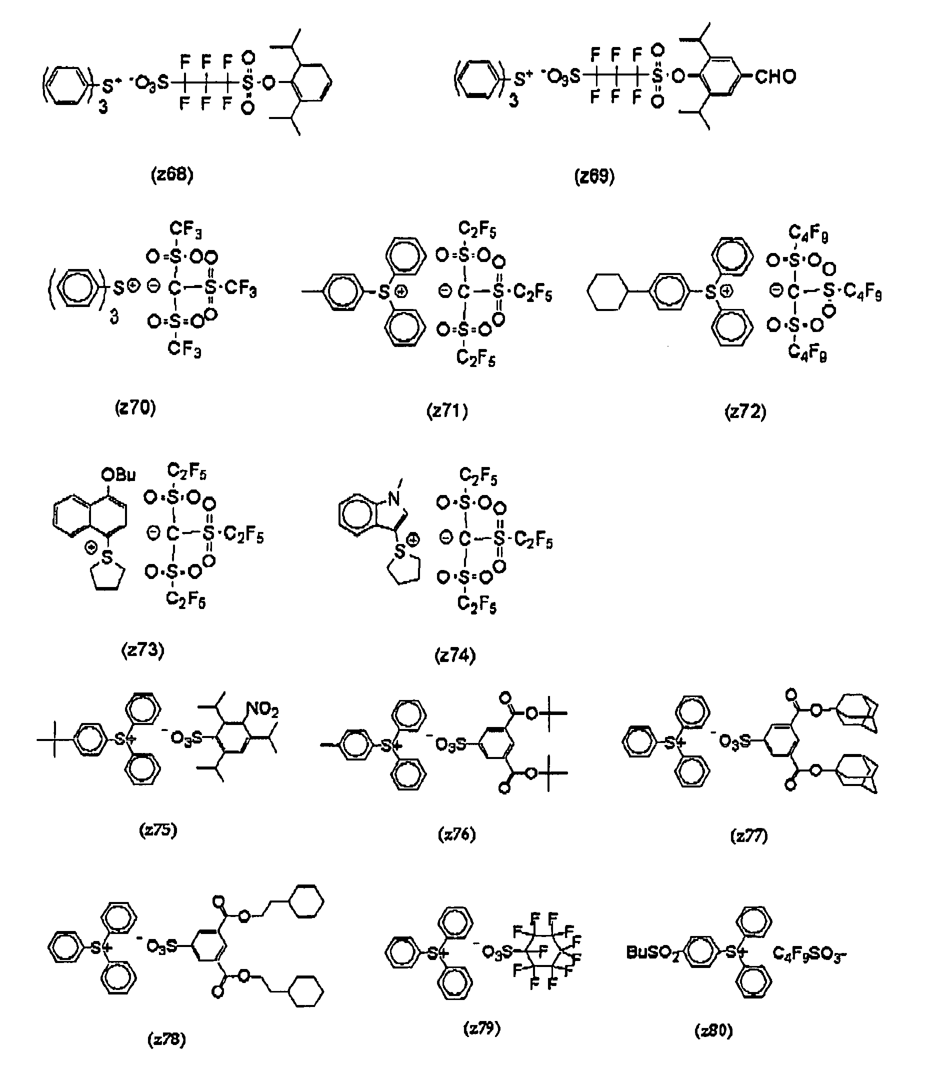

One of these acid generators may be used alone, or two or more kinds thereof may be used in combination. In the case of using two or more kinds in combination, compounds capable of generating two or more organic acids differing in the total number of atoms except for hydrogen atom by 2 or more are preferably combined.

The content of the acid generator in the composition is preferably from 0.1 to 20 mass%, more preferably from 0.5 to 10 mass%, still more preferably from 1 to 7 mass%, based on the entire solid content of the resist composition.

### Organic Basic Compound:

In the present invention, an organic basic compound is preferably used, for example, from the standpoint of enhancing the performance such as resolving power or enhancing the storage stability. The organic basic compound is more preferably a compound containing a nitrogen atom (nitrogen-containing basic compound).

The organic basic compound preferred in the present invention is a compound having basicity stronger than that of phenol.

The preferred chemical environment thereof includes structures of the following formulae (A) to (E). The structures of formulae (B) to (E) each may be a part of a ring structure.

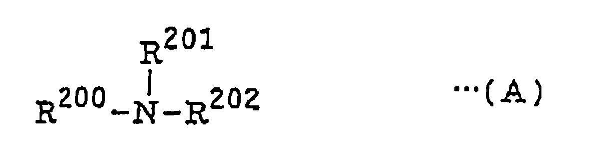

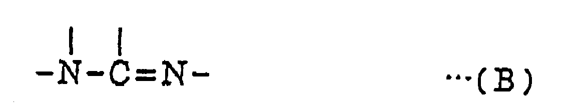

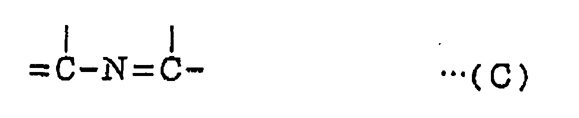

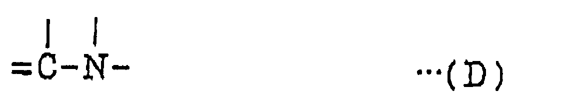

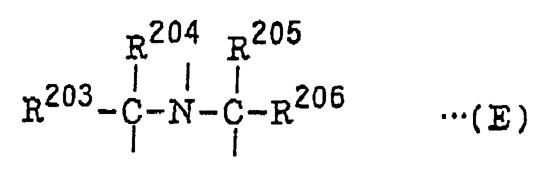

In formula (A), R²⁰⁰, R²⁰¹ and R²⁰², which may be the same or different, each represents a hydrogen atom, an alkyl group or cycloalkyl group having a carbon number of 1 to 20, or an aryl group having a carbon number of 6 to 20, and R²⁰¹ and R²⁰² may combine with each other to form a ring.

The alkyl group, cycloalkyl group and aryl group as R²⁰⁰, R²⁰¹ and R²⁰² each may have a substituent. The alkyl group or cycloalkyl group having a substituent is preferably an aminoalkyl group or aminocycloalkyl group having a carbon number of 1 to 20, or a hydroxyalkyl group having a carbon number of 1 to 20.

In formula (E), R²⁰³, R²⁰⁴, R²⁰⁵ and R²⁰⁶, which may be the same or different, each represents an alkyl group or cycloalkyl group having a carbon number of 1 to 6.

The compound is more preferably a nitrogen-containing basic compound having two or more nitrogen atoms differing in the chemical environment within one molecule, still more preferably a compound containing both a substituted or unsubstituted amino group and a nitrogen-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. Preferred examples of the substituent which these compounds each may have include an amino group, an alkylamino group, an aminoaryl group, an arylamino group, an alkyl group (as the substituted alkyl group, particularly an aminoalkyl group), an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)-piperidine, 4-amino-2,2,6,6-tetramethylpiperidine, 4-piperidinopiperidine, 2-iminopiperidine, 1-(2-aminoethyl)-pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)morpholine.

One of these nitrogen-containing basic compounds may be used alone, or two or more kinds thereof may be used in combination.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred.

One of these nitrogen-containing basic compounds may be used alone, or two or more kinds thereof may be used in combination.

As for the ratio between the acid generator and the organic basic compound used in the composition, the (total amount of acid generators)/(organic basic compound) (molar ratio) is preferably from 2.5 to 300. When this molar ratio is 2.5 or more, high sensitivity is obtained, and when the molar ratio is 300 or less, the resist pattern can be prevented from thickening in aging after exposure until heat treatment and the resolving power can be enhanced. The (total amount of acid generators)/(organic basic compound) (molar ratio) is more preferably from 5.0 to 200, still more preferably from 7.0 to 150.

### Surfactant:

In the present invention, surfactants may be used and this is preferred in view of film-forming property, adhesion of pattern, reduction of development defects, and the like.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate), and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303 and EF352 (produced by Shin-Akita Chemical Co., Ltd.), Megafac F171 and F173 (produced by Dainippon Ink & Chemicals, Inc.), Florad FC430 and FC431 (produced by Sumitomo 3M Inc.), Asahiguard AG710, Surflon S-382, SC101, SC102, SC103, SC104, SC105 and SC106 (produced by Asahi Glass Co., Ltd.), and Troysol S-366 (produced by Troy Chemical Industries, Inc.); an organosiloxane polymer, KP-341 (produced by Shin-Etsu Chemical Co., Ltd.); and acrylic acid-based or methacrylic acid-based (co)polymers Polyflow No. 75 and No. 95 (produced by Kyoeisha Yushi Kagaku Kogyo Co., Ltd.). The blending amount of such a surfactant is usually 2 parts by mass or less, preferably 1 part by mass or less, per 100 parts by mass of the solid content in the composition of the present invention.

One of these surfactants may be added alone, or several kinds thereof may be added in combination.

As for the surfactant, the composition preferably contains any one of fluorine- and/or silicon-containing surfactants (a fluorine-containing surfactant, a silicon-containing surfactant, or a surfactant containing both a fluorine atom and a silicon atom), or two or more kinds thereof.

Examples of these surfactants include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, a polysiloxane polymer KP-341 (produced by Shin-Etsu Chemical Co., Ltd.) may also be used as the silicon-containing surfactant.

Other than these known surfactants, a surfactant using a polymer having a fluoroaliphatic group derived from a fluoroaliphatic compound produced by a telomerization process (also called a telomer process) or an oligomerization process (also called an oligomer process) may be used. The fluoroaliphatic compound can be synthesized by the method described in JP-A-2002-90991.

The polymer having a fluoroaliphatic group is preferably a copolymer of a fluoroaliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly-(oxyethylene and oxypropylene). Furthermore, the copolymer of a fluoroaliphatic group-containing monomer with a (poly(oxyalkylene)) acrylate (or methacrylate) may be not only a binary copolymer but also a ternary or higher copolymer obtained by simultaneously copolymerizing two or more different fluoroaliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a C₆F₁₃ group-containing acrylate (or methacrylate) with a (poly(oxyalkylene)) acrylate (or methacrylate), a copolymer of a C₆F₁₃ group-containing acrylate (or methacrylate) with (poly(oxyethylene)) acrylate (or methacrylate) and (poly(oxypropylene)) acrylate (or methacrylate), a copolymer of a C_{B}F₁₇ group-containing acrylate (or methacrylate) with a (poly(oxyalkylene)) acrylate (or methacrylate), and a copolymer of a C₈F₁₇ group-containing acrylate (or methacrylate) with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the positive resist composition (excluding the solvent).

### Other Components:

The positive resist composition of the present invention may further contain, if desired, a dye, a photobase generator and the like.

### 1. Dye

In the present invention, a dye may be used.

The suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

### 2. Photobase Generator

Examples of the photobase generator which can be added to the composition of the present invention include compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photobase generator which can be suitably used include 2-nitrobenzyl carbamate, 2,5-dinitrobenzylcyclohexyl carbamate, N-cyclohexyl-4-methylphenylsulfonamide and 1,1-dimethyl-2-phenylethyl-N-isopropyl carbamate. Such a photobase generator is added for the purpose of improving the resist profile or the like.

### 3. Solvent

The resist composition of the present invention after dissolving the components described above in a solvent is coated on a support. Usually, the concentration is, in terms of the solid material concentration of all resist components, preferably from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or several kinds thereof are mixed and used.

The positive resist composition of the present invention is coated on a substrate to form a thin film. The thickness of this coated film is preferably from 0.05 to 4.0 µm.

In the present invention, a commercially available inorganic or organic antireflection film may be used, if desired. Furthermore, the antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative/formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film containing a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising a methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series and DUV-40 Series produced by Brewer Science, Inc.; and AR-2, AR-3 and AR-5 produced by Shipley Co., Ltd.

In the production or the like of a precision integrated circuit device, the step of forming a pattern on a resist film is performed by coating the positive resist composition of the present invention on a substrate (for example, a silicon/silicon dioxide-coated substrate, a glass substrate, an ITO substrate or a quartz/chromium oxide-coated substrate) to form a resist film, irradiating thereon actinic rays or radiation such as KrF excimer laser light, electron beam or EUV light, and then subjecting the resist film to heating, development, rinsing and drying, whereby a good resist pattern can be formed.

The alkali developer which can be used in the development is an aqueous solution of alkalis (usually, 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimetylethanolamine, triethanolamine), quaternary ammonium salts (e.g., tetramethylammonium hydroxide, tetraethylammonium hydroxide, choline), and cyclic amines (e.g., pyrrole, piperidine). This aqueous solution of alkalis may be used after adding thereto alcohols such as isopropyl alcohol or a surfactant such as nonionic surfactant, in an appropriate amount.

Among these developers, a quaternary ammonium salt is preferred, and tetramethylammonium hydroxide and choline are more preferred.

The alkali concentration of the alkali developer is usually from 0.1 to 20 mass%, and the pH of the alkali developer is usually from 10 to 15.

### [Example 1]

The present invention is described in greater detail below by referring to Examples, but the present invention should not be construed as being limited thereto.

### [Synthesis Example 1: Synthesis of Resin B-3]

p-Acetoxystyrene and (4'-hydroxyphenyl) methacrylate were charged at a ratio of 60/40 (mole fraction) and dissolved in tetrahydrofuran to prepare 100 mL of a solution having a solid material concentration of 20 mass%. Subsequently, 3 mol% of methyl mercaptopropionate and 4 mol% of a polymerization initiator, V-65, produced by Wako Pure Chemical Industries, Ltd. were added to the solution prepared, and the resulting solution was added dropwise to 10 mL of tetrahydrofuran heated at 60°C, over 4 hours in a nitrogen atmosphere. After the completion of dropwise addition, the reaction solution was heated for 4 hours, and 1 mol% of V-65 was again added, followed by stirring for 4 hours. After the completion of reaction, the reaction solution was cooled to room temperature and then crystallized from 3 L of hexane, and the precipitated white powder was collected by filtration.

The compositional ratio of the polymer determined from C¹³NMR was 58/42. Also, the weight average molecular weight determined by GPC was 9,500 in terms of standard polystyrene, and the dispersity (Mw/Mn) was 1.75.

The resin obtained was vacuum-dried and then dissolved in 100 ml of dehydrated THF (tetrahydrofuran), and 10 ml of cyclohexyl vinyl ether was added thereto. While stirring the resulting solution, 100 mg of p-toluenesulfonic acid was added, and the reaction was allowed to proceed for 3 hours.

The reaction solution was neutralized by adding 1 ml of triethylamine, and thereafter, liquid separation and washing were repeated three times by adding 200 ml of ethyl acetate and further adding 500 ml of distilled water. The ethyl acetate layer was reprecipitated in hexane to obtain the objective Resin B-3 (compositional molar ratio: 43/15/32/10, weight average molecular weight: 2,500, dispersity: 1.30). The glass transition temperature of the resin was measured by DSC and found to be 110°C.

### [Synthesis Example 2: Synthesis of Resin B-1]

p-Acetoxystyrene and indane were charged at a ratio of 90/10 (mole fraction) and dissolved in tetrahydro-furan/methanol (volume ratio: 1/4) to prepare 100 ml of a solution having a solid material concentration of 20 mass%. A polymerization initiator, V-65, produced by Wako Pure Chemical Industries, Ltd. in an amount of 2 mol% based on the monomer was added to the solution prepared above, and the resulting solution was added dropwise to 30 ml of methanol heated to 60°C, over 4 hours in a nitrogen atmosphere. After the completion of dropwise addition, the reaction solution was heated for 4 hours, and V-65 in an amount of 1 mol% based on the monomer was again added, followed by stirring for 4 hours. After the completion of reaction, the reaction solution was cooled to room temperature and after adding 300 ml of methanol thereto, the precipitated white powder was collected by filtration. An operation of dissolving the white powder in tetrahydrofuran, adding hexane thereto and recovering the precipitated polymer was repeated three times.

The compositional ratio of the polymer determined from ¹³C-NMR was 90/10. Also, the weight average molecular weight determined by GPC was 2,300 in terms of standard polystyrene, and the dispersity (Mw/Mn) was 1.35.

The resin obtained was dissolved in 150 ml of ethyl acetate, and 10 ml of sodium methoxide (28% solution) was added thereto, followed by stirring at room temperature of 20 minutes. The resulting solution was neutralized with 1N hydrochloric acid and then subjected to liquid separation and washing with distilled water five times. Subsequently, the ethyl acetate layer was reprecipitated from hexane, and the powder was recovered.

The powder obtained was vacuum-dried and then dissolved in 100 ml of dehydrated THF, and 10 ml of cyclohexyl vinyl ether was added thereto. While stirring the resulting solution, 100 mg of p-toluenesulfonic acid was added, and the reaction was allowed to proceed for 3 hours. The reaction solution was neutralized by adding 1 ml of triethylamine, and then, liquid separation and washing were repeated three times by adding 200 ml of ethyl acetate and further adding 500 ml of distilled water. The ethyl acetate layer was reprecipitated from hexane to obtain the objective resin (compositional molar ratio: 70/20/10, weight average molecular weight: 2,500, dispersity: 1.35). The glass transition temperature of the resin was measured by DSC and found to be 105°C.

### [Synthesis Example 3: Synthesis of Resin B-5]

p-Acetoxystyrene and (6-hydroxynaphthyl)methacrylamide were charged at a ratio of 80/20 (mole fraction) and dissolved in tetrahydrofuran/methoxyethanol (volume ratio: 1:3) to prepare 100 ml of a solution having a solid material concentration of 20 mass%. A polymerization initiator, V-65, produced by Wako Pure Chemical Industries, Ltd. in an amount of 2 mol% based on the monomer was added to the solution prepared above, and the resulting solution was added dropwise to 30 ml of methanol heated to 60°C, over 4 hours in a nitrogen atmosphere. After the completion of dropwise addition, the reaction solution was heated for 4 hours, and V-65 in an amount of 1 mol% based on the monomer was again added, followed by stirring for 4 hours. After the completion of reaction, the reaction solution was cooled to room temperature and after adding 300 ml of methanol thereto, the precipitated white powder was collected by filtration. An operation of dissolving the white powder in tetrahydrofuran, adding hexane thereto and recovering the precipitated polymer was repeated three times.

The compositional ratio of the polymer determined from ¹³C-NMR was 80/20. Also, the weight average molecular weight determined by GPC was 3,000 in terms of standard polystyrene, and the dispersity (Mw/Mn) was 1.30.

The resin obtained was dissolved in 150 ml of ethyl acetate, and 10 ml of sodium methoxide (28% solution) was added thereto, followed by stirring at room temperature of 20 minutes.

The resulting solution was neutralized with 1N hydrochloric acid and then subjected to liquid separation and washing with distilled water five times. Subsequently, the ethyl acetate layer was reprecipitated from hexane, and the powder was recovered.

The powder obtained was vacuum-dried and then dissolved in 100 ml of dehydrated THF, and 10 ml of cyclohexyl vinyl ether was added thereto. While stirring the resulting solution, 100 mg of p-toluenesulfonic acid was added, and the reaction was allowed to proceed for 3 hours. The reaction solution was neutralized by adding 1 ml of triethylamine, and then, liquid separation and washing were repeated three times by adding 200 ml of ethyl acetate and further adding 500 ml of distilled water. The ethyl acetate layer was reprecipitated from hexane to obtain the objective resin (compositional molar ratio: 50/30/20, weight average molecular weight: 3,000, dispersity: 1.30). The glass transition temperature of the resin was measured by DSC and found to be 105°C.

The resins shown in Table 1 were synthesized in the same manner as in Synthesis Example 1. In Table 1, the compositional ratio (by mol, in the order from the left in the structural formula), weight average molecular weight (Mw), dispersity (Mw/Mn), and glass transition temperature Tg (°C) of each resin are shown.

Incidentally, B-3*¹ was obtained by decreasing 1 mass% from the amount added of the polymerization initiator V-65 in B-3. Similarly, B-3*² was obtained by increasing 1 mass%. As for other resins marked with *, the denoted resin was obtained in the same manner by increasing or decreasing the amount of the initiator.

**Table 1**

| Resin | Compositional Ratio (by mol) | weight Average Molecular Weight | Dispersity | Glass Transition Temperature (°C) |
|---|---|---|---|---|
| (B-1) | 70/20/10 | 2500 | 1.35 | 105°c |
| (B-3) | 43/15/32/10 | 2500 | 1.30 | 110°C |
| (B-5) | 50/30/20 | 3000 | 1.30 | 105°C |
| (B-7) | 60/20/20 | 2900 | 1.25 | 110°C |
| (B-8) | 45/30/25 | 2700 | 1.20 | 105°C |
| (B-14) | 50/30/20 | 3000 | 1.30 | 110°C |
| (B-3)*¹ | 60/20/15/5 | 4600 | 1.65 | 95°C |
| (B-3)*² | 30/10/45/15 | 4400 | 1.65 | 153°c |
| (B-1)*¹ | 70/20/10 | 2550 | 2.71 | 60°C |
| (B-1)*² | 70/20/10 | 1400 | 2.65 | 40°C |
| (B-1)*³ | 70/20/10 | 3600 | 1.35 | 110°C |
| (B-3)*³ | 43/15/32/10 | 2500 | 2.82 | 55°C |
| (B-3)*⁴ | 43/15/32/10 | 1450 | 3.25 | 65°C |
| (B-3)*⁵ | 43/15/32/10 | 3560 | 1.38 | 65°C |

The sulfonic acid generators and carboxylic acid generators used in Examples of the present invention all were synthesized by a known synthesis method such as synthesis method described in JP-A-2002-27806.

### [Example 1]

### (1) Preparation and Coating of Positive Resist

| | |
|---|---|
| Resin B-3 | 0.93 g |
| Acid Generator z2 | 0.06 g |

These components were dissolved in 8.8 g of propylene glycol monomethyl ether acetate, and 0.003 g of D-1 (see below) as the organic basic compound and 0.001 g of Megafac F176 (produced by Dainippon Ink & Chemicals, Inc., hereinafter simply referred to as "W-1") as the surfactant were further added thereto and dissolved. The obtained solution was microfiltered through a polyethylene filter having a pore size of 0.1 µm to obtain a resist solution.

This resist solution was coated on a 6-inch silicon wafer by using a spin coater, Mark 8, manufactured by Tokyo Electron Ltd. and baked at 110°C for 90 seconds to obtain a uniform film having a thickness of 0.25 µm.

### (2) Formation of Positive Resist Pattern

The resist film was then irradiated with electron beams by using an electron beam imaging apparatus (HL750, manufactured by Hitachi Ltd., accelerating voltage: 50 KeV). After the irradiation, the resist film was baked at 110°C for 90 seconds, dipped in an aqueous 2.38 mass% tetramethylammonium hydroxide (TMAH) solution for 60 seconds, rinsed with water for 30 seconds and then dried. The obtained pattern was evaluated by the following methods.

### (2-1) Sensitivity

The cross-sectional profile of the pattern obtained was observed using a scanning electron microscope (S-4300, manufactured by Hitachi, Ltd.). The minimum irradiation energy for resolving a 0.12-µm line (line: space = 1:1) was taken as the sensitivity.

### (2-2) Pattern Profile

The cross-sectional profile of a 0.12-µm line pattern at the irradiation dose giving the sensitivity above was observed by a scanning electron microscope (s-4300, manufactured by Hitachi, Ltd.) and evaluated on a three-step scale of rectangular, slightly tapered, and tapered.

### (2-3) Defocus Latitude Depended on Line Pitch

In a 0.12-µm line pattern at the irradiation dose giving the sensitivity above, the line width of a dense pattern (line:space = 1:1) and the line width of an isolated pattern were measured. The difference therebetween was taken as the defocus latitude depended on line pitch.

### (Increase Ratio of Dissolution Rate)

The resist solution was coated on a 6-inch silicon wafer by using a spin coater, Mark 8, manufactured by Tokyo Electron Ltd. and baked at 110°C for 90 seconds to obtain a uniform film having a thickness of 0.25 µm.

This resist film was irradiated with electron beams (open frame) by using an electron beam imaging apparatus (HL750, manufactured by Hitachi Ltd., accelerating voltage: 50 KeV) and then baked at 110°C for 90 seconds. The dissolution rates in the exposed area and unexposed area for an aqueous 2.38 mass% tetramethylammonium hydroxide (TMAH) solution were measured using a resist solution analyzer manufactured by Litho Tech Japan Co., Ltd., and the ratio of dissolution rate in exposed area/dissolution rate in unexposed area was calculated as the increase ratio of dissolution rate (dissolution contrast).

The results of Example 1 were very good, that is, the sensitivity was 30 µC/cm², the pattern profile was rectangular, the defocus latitude depended on line pitch was 9 nm, and the dissolution rate ratio was 900.

### [Examples 2 to 6 and Comparative Examples 1 to 8]

Using the compounds shown in Table 2, the preparation and coating of resist and the evaluation by electron beam exposure were performed thoroughly in the same manner as in Example 1. The evaluation results are shown in Table 2.

In the Table, denotations of organic basic compounds and surfactants are as follows.

### [Organic Basic Compound]

D-1: tri-n-hexylamine
D-2: 2,4,6-triphenylimidazole
D-3: tetra-(n-butyl)ammonium hydroxide

### [Surfactant]

W-1: fluorine-containing surfactant, Megafac F-176 (produced by Dainippon Ink & Chemicals, Inc.)
W-2: fluorine/silicon-containing surfactant, Megafac R08 (produced by Dainippon Ink & Chemicals, Inc.)
W-3: silicon-containing surfactant, Polysiloxane Polymer KP-341 (produced by Shin-Etsu Chemical Co., Ltd.)

**Table 2**

| Resin | Resin (0.93 g) | Acid Generator (0.06 g) | Basic Compound (0.003 g) | Surfactant (0.001 g) | Dissolution Contrast | Sensitivity (µC/cm²) | Pattern Profile | Defocus Latitude Depended on Line Pitch (nm) |
|---|---|---|---|---|---|---|---|---|
| Example 1 | (B-3) | (z2) | D-1 | W-1 | 900 | 30 | good | 9 |
| Example 2 | (B-1) | (z12) | D-3 | W-1 | 2000 | 34 | good | 10 |
| Example 3 | (B-5) | (z37) | D-1 | W-2 | 500 | 30 | good | 11 |
| Example 4 | (B-7) | (z35) | D-2 | W-1 | 1300 | 35 | good | 9 |
| Example 5 | (B-8) | (z55) | D-1 | W-3 | 3000 | 34 | good | 11 |
| Example 6 | (B-14) | (z2) | D-3 | W-1 | 5000 | 32 | good | 10 |
| Comparative Example 1 | (B-3)*¹ | (z2) | D-1 | W-1 | 450 | 26 | round top | 23 |
| Comparative Example 2 | (B-3)*² | (z2) | D-1 | W-1 | 6000 | 45 | T-top | 11 |
| Comparative Example 3 | (B-1)*¹ | (z2) | D-1 | W-1 | 5500 | 24 | round top | 32 |
| Comparative Example 4 | (B-1)*² | (z2) | D-1 | W-1 | 6500 | 22 | round top | 28 |
| Comparative Example 5 | (B-1)*³ | (z2) | D-1 | W-1 | 100 | 38 | T-top | 10 |
| Comparative Example 6 | (B-3)*³ | (z2) | D-1 | W-1 | 6500 | 23 | round top | 30 |
| Comparative Example 7 | (B-3)*⁴ | (z2) | D-1 | W-1 | 5500 | 21 | round top | 25 |
| Comparative Example 8 | (B-3)*⁵ | (z2) | D-1 | W-1 | 100 | 35 | T-top | 10 |

The sensitivity, pattern profile and dissolution contrast were determined in the same manner as in EB exposure except for changing the light source to an EUV exposure device (manufactured by Litho Tech Japan Co., Ltd., wavelength: 13 nm) from the electron beam. The results are shown in Table 3.

**Table 3 EUV Exposure Results**

| | Resin (0.93 g) | Acid Generator (0.06 g) | Compound (0.003 g) | Surfactant (0.001 g) | Dissolution Contrast | Sensitivity (mJ/cm²) | Pattern Profile |
|---|---|---|---|---|---|---|---|
| Example 7 | (B-3) | (z2) | D-1 | W-1 | 500 | 16 | good |
| Example 8 | (B-1) | (z12) | D-3 | w-1 | 1200 | 17 | good |
| Example 9 | (B-5) | (z37) | D-1 | W-2 | 200 | 16 | good |
| Example 10 | (B-7) | (z35) | D-2 | W-1 | 300 | 17 | good |
| Example 11 | (B-8) | (z55) | D-1 | W-3 | 1500 | 18 | good |
| Example 12 | (B-14) | (z2) | D-3 | W-1 | 500 | 16 | good |
| Comparative Example 9 | (B-3)*¹ | (z2) | D-1 | W-1 | 80 | 13 | round top |
| Comparative Example 10 | (B-3)*² | (z2) | D-1 | w-1 | 4000 | 26 | T-top |

It is seen from the results above that the resist composition of the present invention is excellent in various performances such as sensitivity and pattern profile even when the exposure is performed using EB, EUV or the like.

According to the present invention, in connection with the pattern formation by the irradiation of electron beam, KrF excimer laser light, EUV light or the like, a positive resist composition having high sensitivity and good performances in terms of pattern profile, defocus latitude depended on line pitch, and dissolution contrast, and a pattern forming method using the composition can be provided.

The entire disclosure of each and every foreign patent application from which the benefit of foreign priority has been claimed in the present application is incorporated herein by reference, as if fully set forth.

## Claims

1. A positive resist composition, comprising:
(A) a resin having a property of becoming soluble in an alkali developer under an action of an acid and having a phenolic hydroxyl group and a weight average molecular weight of 1,500 to 3,500; and
(B) a compound capable of generating a sulfonic acid upon irradiation with actinic rays or radiation,
wherein a ratio of dissolution rates of an exposed area and an unexposed area in an aqueous 2.38 wt% tetramethylammonium hydroxide at 23°C under atmospheric pressure is in a range from 200 to 5,000 times.

2. The positive resist composition according to claim 1,
wherein the resin (A) contains at least one of a repeating unit represented by formula (1) and a repeating unit represented by formula (2): 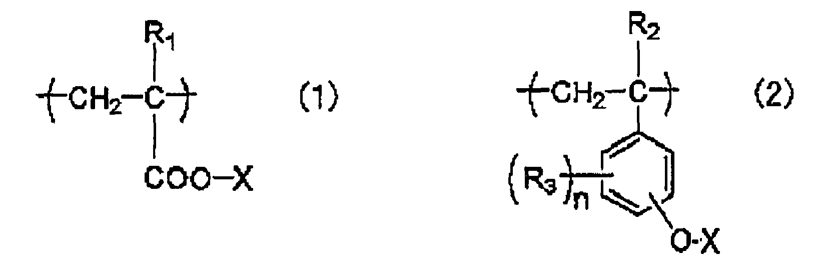 wherein R₁ and R₂ each independently represents a hydrogen atom, a halogen atom, an alkyl group or a cyano group;
X each independently represents a cyclic hydrocarbon structure-containing group capable of leaving under an action of an acid;
R₃ represents a monovalent organic group, a nitro group or a halogen atom; and
n represents an integer of 0 to 4.

3. The positive resist composition according to claim 2,
wherein the cyclic hydrocarbon structure-containing group represented by X in formula (1) is a group represented by any one of formulae (pI) to (pVI) : 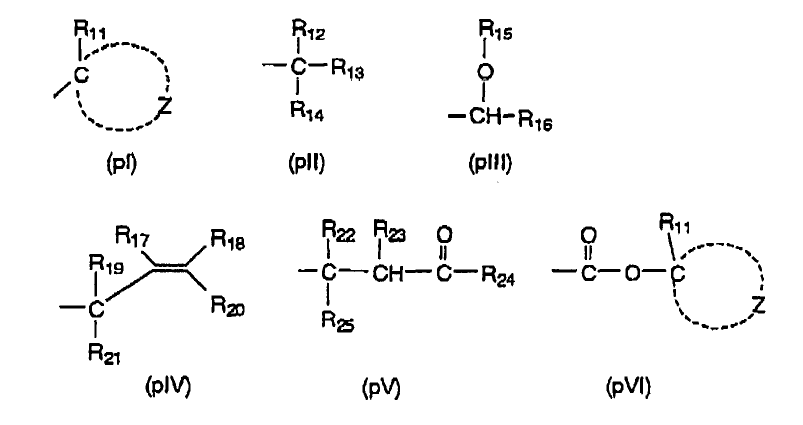 R₁₁ represents a methyl group, an ethyl group, an n-propyl group, an isopropyl group, an n-butyl group, an isobutyl group or a sec-butyl group;
Z represents an atomic group necessary for forming a cyclic hydrocarbon together with the carbon atom;
R₁₂ to R₁₆ each independently represents a linear or branched alkyl group having a carbon number of 1 to 4, or a hydrocarbon group, provided that at least one of R₁₂ to R₁₄ or either R₁₅ or R₁₆ represents a cyclic hydrocarbon;
R₁₇ to R₂₁ each independently represents a hydrogen atom, a linear or branched alkyl group having a carbon number of 1 to 4, or a cyclic hydrocarbon, provided that at least one of R₁₇ to R₂₁ represents a cyclic hydrocarbon, and either R₁₉ or R₂₁ represents a linear or branched alkyl group having a carbon number of 1 to 4, or a cyclic hydrocarbon; and
R₂₂ to R₂₅ each independently represents a hydrogen atom, a linear or branched hydrocarbon group having a carbon number of 1 to 4, or a cyclic hydrocarbon, provided that at least one of R₂₂ to R₂₅ represents a cyclic hydrocarbon, and R₂₃ and R₂₄ may combine with each other to form a ring.

4. The positive resist composition according to claim 2,
wherein the cyclic hydrocarbon structure-containing group represented by X in formula (1) is a group represented by formula (3): 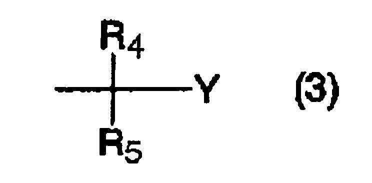 R₉ and R₅ each independently represents an alkyl group; and
Y represents an alicyclic hydrocarbon group.

5. The positive resist composition according to claim 2,
wherein the resin (A) further contains a cyclic hydrocarbon structure-containing repeating unit which is alkali-insoluble and inert to an acid.

6. The positive resist composition according to claim 2,
wherein the resin (A) further contains a repeating unit represented by formula (A4): 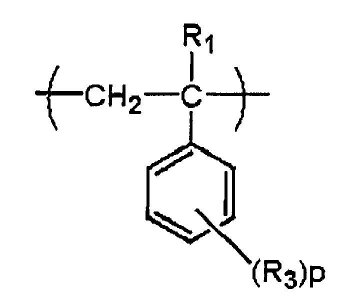 R₁ represents a hydrogen atom, a halogen atom, an alkyl group or a cyano group;
R₃ represents a monovalent organic group not having a property of decomposing under an action of an acid, or represents a hydrogen atom, a halogen atom or a nitro group; and
p represents an integer of 0 to 5 and when p is an integer of 2 or more, the plurality of R₃'s may be the same or different.

7. The positive resist composition according to claim 1,
wherein the resin (A) has a weight average molecular weight (Mw) of from 2,000 to 3,000.

8. The positive resist composition according to claim 1,
wherein the resin (A) has a dispersity (Mw/Mn) of 1.5 or less.

9. The positive resist composition according to claim 1,
wherein the resin (A) has a glass transition temperature of from 100 to 150°C.

10. The positive resist composition according to claim 9,
wherein the resin (A) has a glass transition temperature of from 100 to 110°C.

11. A pattern forming method, comprising:
forming a resist film from the positive resist composition according to claim 1; and
exposing and developing the resist film.
